# EUROPEAN PATENT APPLICATION

(11) **EP 4 746 595 A1**
(43) Date of publication of application: **20.05.2026**
(21) Application number: 24212804.9
(22) Date of filing: 13.11.2024
(51) Int. Cl.: H05K 3/46

(54) **COMPONENT CARRIER AND METHOD FOR MANUFACTURING A COMPONENT CARRIER**

(71) Applicant: AT&S Austria Technologie & Systemtechnik Aktiengesellschaft, 8700 Leoben (AT)
(72) Inventor: OGGIONI, Stefano Sergio, 8700 Leoben (AT); WEIS, Gerald, 8600 Bruck an der Mur (AT); SHIBATA, Misaki, 8700 Leoben (AT); WEIDINGER, Gerald, 8700 Leoben (AT); KIRCHHEIMER, Karl Philipp, 8700 Leoben (AT)
(74) Representative: Donatello, Daniele

(57) **Abstract**

The present invention relates to a component carrier (100) a method for manufacturing thereof, wherein the component carrier (100) comprises a stack (110) comprising at least one electrically conductive layer structure (120) and at least one electrically insulating layer structure (130), wherein at least one surface (140) of said at least one electrically conductive layer structure (120) is divided in at least one first portion (150) and at least one second portion (160), said at least one first portion (150) and said at least one second portion (160) being adjacent one to the other, said at least one first portion (150) having a higher conductivity with respect to that of said at least one second portion (160), wherein on said at least one first portion (150) metallic nanostructures and/or microstructures (170) are provided.

## Description

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

For example, providing metallic nanostructures and/or microstructures on a dedicated surface of an electrically conductive layer structure, may be challenging.

There may be a need to provide metallic nanostructures and/or microstructures on a dedicated surface of an electrically conductive layer structure of a component carrier in an efficient, reliable, and robust manner.

In order to achieve the object defined above, a component carrier and a method of manufacturing the component carrier according to the independent claims are provided. The dependent claims describe advantageous embodiments.

### Field of the Invention

The present invention generally relates to a component carrier comprising a stack comprising at least one electrically conductive layer structure and at least one electrically insulating layer structure, at least one surface of said at least one electrically conductive layer structure is divided in at least one first portion and at least one second portion, said at least one first portion and at least one second portion being adjacent one to the other. Said at least one first portion has a higher conductivity with respect to that of said at least one second portion, wherein on said at least one first portion metallic nanostructures and/or microstructures are provided.

Further, the present invention relates to a method for manufacturing a component carrier as described.

According to a first aspect of the present invention, a component carrier is provided, wherein the component carrier comprises a stack comprising at least one electrically conductive layer structure and at least one electrically insulating layer structure, wherein at least one surface of said at least one electrically conductive layer structure is divided in at least one first portion and at least one second portion, said at least one first portion and said at least one second portion being adjacent one to the other, said at least one first portion having a higher conductivity with respect to that of said at least one second portion, wherein on said at least one first portion metallic nanostructures and/or microstructures are provided. Preferably, the at least one electrically conductive layer structure may be located at one of the two main surfaces of the component carrier.

According to the second aspect of the present invention, a method of manufacturing a component carrier is provided, wherein the method comprises the steps of: providing a stack comprising at least one electrically conductive layer structure and at least one electrically insulating layer structure, dividing at least one surface of said at least one electrically conductive layer structure into at least one first portion and at least one second portion, said at least one first portion and said at least one second portion being adjacent one to the other, said at least one first portion has a higher conductivity with respect to that of the at least one second portion and (thereafter) providing metallic nanostructures and/or microstructures on said first portion.

A component carrier according to the first aspect of the present invention is created, in which at least one surface of at least one electrically conductive layer structure is divided in at least one first portion and at least one second portion. Said at least one first portion and at least one second portion are adjacent one to the other. Furthermore, the at least one first portion has a higher conductivity, in particular a higher electrically conductivity, with respect to that of the at least one second portion. Additionally, the at least one first portion may have further different physical properties, for example thermal conductivity and/or surface energy, with respect to that of the at least one second portion. Due to the physical properties, especially but not exclusively restricted to the electrically conductivity, metallic nanostructures and/or microstructures are provided on the surface of/at the first portion. Additionally or alternatively, due to the physical properties, especially but not exclusively restricted to the electrically conductivity, the at least one second portion may be free from metallic nanostructure and/or microstructures. Without the division of the at least one electrically conductive layer structure in at least one first portion and at least one second portion, metallic nanostructures and/or microstructures are provided to an electrically conductive layer structure without any control at which position the metallic nanostructures and/or microstructures are located. According to the first aspect and the second aspect of the invention, metallic nanostructures and/or microstructures are provided at at least one dedicated surface of an electrically conductive layer structure. This may give the further advantage of creating a more complex design of the component carrier, in particular the electrically conductive layer structures.

In the context of the present application, the term "component carrier" may particularly denote any support structure which is capable of accommodating one or more components thereon and/or therein for providing mechanical support and/or electrical connectivity. A component carrier may also support thermal management, wherein the component carrier may in particular serve as a heat guiding and/or conduction structure, preferably supporting heat dissipation. In other words, a component carrier may be configured as a mechanical and/or electronic and/or thermal (acting) carrier for components.

In particular, a component carrier may be one of or may be configured as a printed circuit board (PCB), an interposer, in particular an organic interposer, and an IC (integrated circuit) substrate. A component carrier may also be a hybrid board combining different ones of the above-mentioned types of component carriers.

In some embodiments, a component carrier may in particular comprise one or more stacks and/or more than at least two electrically conductive layer structures. A component carrier may, for example, also comprise a solder resist layer structure and/or a protective layer structure. A protective layer structure may also be functionalized as an electrically conductive layer structure for at least one component.

In at least one embodiment, the component carrier may in particular be a laminate-type component carrier. In such an embodiment, the component carrier may in particular be a compound of multiple layer structures which are stacked one above the other and which are connected together by applying a pressing force and/or heat, in particular with simultaneous application of vacuum.

In the context of the present application, the term "printed circuit board" (PCB) may particularly denote a component carrier, in particular a plate-shaped component carrier, which is preferably formed by laminating several layer structures, for instance by applying pressure and/or by the supply of thermal energy. A PCB comprises in particular at least one insulating layer structure.

In at least one embodiment, in particular in a preferred embodiment of a PCB, the PCB is in particular formed by laminating several electrically conductive layer structures with several electrically insulating layer structures. The insulating layer structures may in particular be arranged in between the electrically conductive layer structures, wherein the electrically conductive layer structures and the insulating layer structures may be arranged alternating in stacking direction.

As preferred materials for PCB technology, the electrically conductive layer structures may be made of copper and/or contain at least a certain and defined amount of copper as it is well-known from proper art and usual, whereas the electrically insulating layer structures may comprise resin and/or glass fibers, so-called prepreg or FR4 material. The electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole may either connect the whole stack, (through-hole connections extending through several layers or the entire stack), or the filled hole may connect at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board may in particular be configured for accommodating one or more components on one or both opposing main surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

A dielectric part of a substrate (of an IC substrate) may be composed of resin with reinforcing particles (such as reinforcing spheres, in particular glass spheres).

In the context of the present application, the term "interposer" may in particularly denote a physical structure configured to bridge at least one electrical connection. An interposer may in particular be a physical interface layer structure. An interposer may in particular be configured to spread an electrical connection to a wider pitch and/or to bridge between different connection types. An interposer can be made of various materials, including silicon, glass, or organic substrates. An IC substrate or interposer may in particular comprise or consist of an inorganic layer structure or at least a layer of glass, silicon (Si) and/or a photo-imageable or dry-etchable organic material like epoxy-based build-up material (such as epoxy-based build-up film) or polymer compounds (which may or may not include photo- and/or thermosensitive molecules) like polyimide or polybenzoxazole as electrically insulating material.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular solder lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride and/or gallium arsenide and/or indium phosphide. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above-mentioned example, such as: MoS₂, CuGaOz, AgAlO₂, LiGaTe₂, AgInSe₂, CuFeS₂, BeO.

In the context of the present application, the term "component" may particularly denote an electronic component which is configured to be mounted on and/or to be embedded into a component carrier, wherein the component may further in particular be configured to be electrically connected to the component carrier. A component can be an inorganic component (such as, for example, a semiconductor component) or a component comprising inorganic material and/or metal material and/or a combination thereof or consisting thereof.

A component may in particular be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminum oxide (Al₂O₃) or aluminum nitride (AIN). In order to increase the heat exchange capacity, other geometries with increased surface area are frequently used as well. Further-more, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microoptoelectromechanical system (MOEMS), a microprocessor, a capacitor, a resistor, an inductance, a battery, a switch, a camera, an antenna, a logic chip, and an energy harvesting unit. However, in addition or alternatively, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In the context of the present application, the term "stack" may particularly denote an arrangement of multiple planar layer structures which are mounted in parallel on top of one another. Some of the layer structures of the stack described herein may be stacked directly onto each other, that means with not further layer structure or component in between or indirectly, wherein between other layer structures described in the present application, further layer structures or components or the like may be arranged which are not described in the present application unless explicitly described to the contrary.

In the context of the present application, the term "electrically conductive layer structure" may particularly denote a layer structure which is electrically conductive. An electrically conductive layer structure may in particular comprise one or more conductive pathways, tracks, and/or signal traces and/or through connections such as vias and holes and/or interconnection structures for interconnection of the layers and/or for connection with other elements and/or components such as bumps, pillars or the like. These electrically conductive structures may for example be etched from copper sheets and may, for example, be laminated onto an electrically non-conductive or electrically insulating layer structure, which the component carrier may comprise additionally in at least one embodiment. Additionally or alternatively, the electrically conductive layer structure may be produced by an additive process, for example SAP or mSAP, wherein SAP stands for "Semi-Additive Process" and mSAP denotes the "modified Semi-Additive Process", wherein both processes SAP and mSAP are well-known from prior art. In an example, the SAP and/or mSAP may comprise acidic conditions and/or alkaline conditions.

In at least one embodiment, the at least one electrically conductive layer structure of the component carrier comprises at least one of the following group consisting of: copper, aluminum, nickel, silver, gold, palladium, tungsten and magnesium and/or an alloy comprising at least one material component of the aforementioned group. Although copper is usually preferred, other materials or coated versions thereof are possible as well, in particular coated with supra-conductive material or conductive polymers, such as graphene or poly(3,4-ethylenedioxythiophene) (PEDOT) or polyaniline, respectively.

In the context of the present application, the term "electrically insulating layer structure" may denote a layer structure which is electrically non-conductive.

The at least one electrically insulating layer structure may comprise at least one of the following group consisting of: a resin or a polymer, such as epoxy resin, cyanate ester resin, benzocyclobutene resin, bismaleimidetriazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, (hollow) spheres or other kinds of filler particles, for example made of glass (multilayer glass) in order to form a composite, could be used as well. A semi-cured resin in combination with a reinforcing agent, for example fibers impregnated with the above-mentioned resins, is called prepreg and may also be used. These prepregs are often named after their properties for example FR4 or FR5, which describe their flame-retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating layer structures.

In the context of the present application, the term "layer structure" may particularly denote a continuous layer, a patterned layer or a plurality of nonconsecutive islands within a common plane. A layer structure can comprise at least one protruding element such as, for example, one or more solder bumps, copper bumps, pillars or other bonding structures like these, wherein the at least one protruding element may in particular protrude beyond the surface of a layer structure.

In at least one embodiment of the present invention, at least one body and/or layer structure of the component carrier may comprise a main surface, wherein in the context of the present application, the term "main surface" of a body or a layer structure may particularly denote one of the two largest opposing surfaces of the body or the layer structure or the outermost layer (structure) of the component carriers. The main surfaces may be connected by circumferential side walls. The thickness of a body or a layer structure, such as a stack, may be defined by the distance between the two opposing main surfaces, in particular in direction perpendicular to the extension of the main surface, in particular perpendicular to its planar extension.

In the context of the present application, the term "thickness direction" or "stacking direction" may particularly refer to a direction perpendicular to a planar extension of at least one layer structure of the stack.

At least one cavity of the component carrier may have been created at least partially or completely by a mechanical manufacturing step, for instance by drilling and/or milling, in particular by laser drilling and/or mechanical drilling. Additionally or alternatively, an etching process may be used to create at least one cavity of the component carrier at least partially. However, material removal by laser drilling is preferred. This kind of material removal allows very precise and efficient material removal without significant introduction of mechanical stress or other significant unwanted effects into the surrounding material. Further, the resulting surface properties enable the establishment of high-quality electrical connections. In addition, laser material removal allows to handle various materials and a plurality of different cavity sizes in a very easy manner.

In the context of the present application, the term "at least one surface of said at least one electrically conductive layer structure is divided in at least one first portion and at least one second portion" may particular denote that the surface of the electrically conductive layer structure is segmented into at least two distinguishable parts. In an example, the at least two distinguishable parts may belong to a common surface and to a common material. In another example, the at least two distinguishable parts may belong to a common surface but to at least two different materials. One of the at least two distinguishable parts may be associated to the first portion and the other of the at least two distinguishable parts may be associated to the second portion. Additionally or alternatively, the surface of the at least one electrically conductive layer structure may be segmented into at least three distinguishable parts. The different portions may comprise different physical properties, for example surface roughness and/or surface energy and thus may be further distinguishable from each other. Optionally the volume of the electrically conductive layer structure may be divided the same way as the surface of the electrically conductive layer structure.

In the context of the present application, the term "being adjacent one to the other" may particular denote that the at least one first portion of the electrically conductive layer structure and the at least one second portion of the electrically conductive layer structure are located in the same vertical level regarding thickness direction and are located in lateral close proximity next to each other. In an example, the at least one first portion of the electrically conductive layer structure and the at least one second portion of the electrically conductive layer structure may be in direct lateral proximity to each other, defining at least one common boundary interface. In another example, the at least one first portion of the electrically conductive layer structure and the at least one second portion of the electrically conductive layer structure may be laterally separated, in particular spaced, with each other, for example only by an electrically insulating layer structure. In a further example, the at least one first portion and the at least one second portion may be associated to the same electrically conductive layer structure. Still in another example, the at least one first portion may be associated to a first electrically conductive layer structure whereas the at least one second portion may be associated to a second electrically conductive layer structure. In the context of the present application, the term "associated" may mean that two things are related with another, in particular connected to another. In an example, the at least one first portion and the at least one second portion may be connected to the same electrically conductive layer structure. Preferably, the at least one first portion and the at least one second portion may be connected one to each other within the same vertical thickness of the at least one first portion and the at least one second portion.

In the context of the present application, the term "nanostructures- and/or microstructures" may particularly denote physical structures with dimensions in the range of nanometers to micrometers, in particular having dimensions in a range between 0.1 nm and 10 micrometers, more particularly in a range between 1 nm and 500 nm. A sheet having a surface equipped with such nanostructures and/or microstructures, for instance in an ordered way (for example in rows and columns) or in a random way, may provide specific properties in terms of adhesion with adjacent component carrier material. Depending on the material, shape, dimension, coating and arrangement of the nanostructures and/or microstructures on the sheet surface, the nanostructures and/or microstructures may have an adhesive effect (such as at a leg of a gecko) or a repellent effect (such as on a surface of a lotus flower). A sheet may have at least 100, in particular at least 1000, nanostructures and/or microstructures. For instance, a sheet with nanostructures providing an adhesive property may be converted into a sheet with nanostructures providing a non-adhesive or even repellent property by a corresponding surface coating of the nanostructures and/or microstructures (for instance with a waxy material). For instance, the nanostructures and/or microstructures may be nano- and/or microprotrusions and/or nano- and/or microindentations. Preferably, the nanostructure and/or microstructures may be nanowires, in particular copper nanowires. In an example, the nanowires may have a cylindrical shape. In another example, the nanowires may have an aspect ratio of greater then 2, in particular greater than 5, more in particular greater than 10. This means that the radial extension of the nanowires is shorter by a factor of 2, in particular 5, more in particular 10, than the axial extension of the cylindrical shaped nanowire(s).

### Description of Exemplary Embodiments

According to a preferred embodiment of the invention, an electrically insulating material is provided, said electrically insulating material covering said at least one second portion. The electrically insulating material may influence the conductivity at the at least one surface of the at least one electrically conductive layer structure, consequently affecting, in particular interfering, more in particular preventing, metallic nanostructures and/or microstructures to be provided at the at least one second portion. The electrically insulating material may act as a protection material influencing the metallic nanostructures and/or microstructures to be provided, in particular grow on, the at least one second portion.

According to another embodiment of the invention, a chemical composition, in particular a metal salt, more in particular a metal oxide or a metal nitride, is provided, said chemical composition covering said at least one second portion. Chemically modifying by providing a chemical composition the at least on second surface portion may be easily done by a surface treatment. Thereby use of well-known process steps in component carrier manufacturing may ensure a reliable modification of a surface of at least one electrically conductive layer structure, in particular the respective conductivity, preferably reducing the respective conductivity value with respect to the surface not covered by said chemical composition (i.e. that of the first portion). Additionally or alternatively, the chemical composition may further impart advantageous physical properties, for example an adhesion promoting property, to the at least one second portion of the electrically conductive layer structure.

In the context of this application the term "metal salt" may refer to a chemical compound comprising a metal cation and a non-metal anion. In an example the metal salt is a result between a metal and an acid or a base. Examples of such a metal may include: copper, nickel, gold, silver, cobalt, chromium, magnesium, sodium, palladium, tin. Examples of acids may include: sulphuric acid, hydrochloric acid, nitric acid, phosphoric acid ect. The metal salt being selected accordingly, for example as sulfate, chloride, nitrate, or phosphate. In another example, a base may comprise sodium hydroxide, potassium hydroxide, lithium hydroxide, magnesium hydroxide, calcium hydroxide or water. Accordingly, a metal salt can e.g. copper hydroxide or silver hydroxide. Additionally or alternatively, a dehydration reaction may happen with the hydroxide comprising metal salt, for example copper hydroxide or silver hydroxide thereby generating metal oxides, for example copper oxide or silver oxide. Further examples for metal salts may be copper sulfate, copper chloride, silver nitrate, silver phosphate, gold chloride, gold bromide, copper nitride or silver nitride.

According to a further embodiment of the invention, a coating layer is provided, said coating layer covering said at least one second portion. In an example, a polymeric material, in particular an organic polymeric material, for example an epoxy resin, may be applied by a coating step. This may bring the advantage that due to the fact that a coating step is a well-known and established manufacturing process step in component carrier production, a reliable application of the coating layer on the second portion is ensured, influencing the conductivity at the at least one surface of the at least one electrically conductive layer structure in an easy and precise manner. Additionally or alternatively, the coating layer may be applied to at least one the second portion very precisely, for example by using a laser assisted process.

According to a preferred embodiment of the invention, said electrically insulating material and/or said chemical composition and/or said coating layer is located, in particular sandwiched, between said at least one second portion and the at least one electrically insulating layer structure. This may bring the advantage of ensuring a high integrity of the stack of the component carrier, since the electrically insulating material and/or the chemical composition and/or coating layer may have good interaction, for example adhesion, with the at least one second portion and the at least one electrically insulating material.

According to another embodiment of the invention, the metallic nanostructures and/or microstructures are in direct contact with said at least one electrically insulating layer structure and/or with said electrically insulating material and/or said chemical composition and/or said coating layer on said at least one second portion. This may bring the advantage of increasing the adhesion between the at least one electrically insulating layer structure and/or said electrically insulating material and/or said chemical composition and/or said coating layer with the electrically conductive layer structure, since the surface area of the electrically conductive layer structure is drastically increased by the provision of the metallic nanostructures and/or microstructures.

According to a further embodiment of the invention, the metallic nanostructures and/or microstructures are in direct contact with the at least one electrically conductive layer structure. Preferably, the metallic nanostructures and/or microstructures are in direct contact with the at least one electrically conductive layer structure which is located at at least one of the two main surfaces of the component carrier. Additionally, the metallic nanostructure and/or microstructures may be in direct contact with said electrically insulating material and/or said chemical composition and/or said coating layer on of said at least one second portion. This may bring the advantage of reliably transmitting electronic signals and/or voltage and/or electric current and/or thermal energy from the at least one first portion to the metallic nanostructures and/or microstructures.

According to a preferred embodiment of the invention, said electrically insulating material and/or said chemical composition and/or said coating layer covering the surface of said at least one second portion comprises a thickness being different, in particular lower, than the thickness of the at least one electrically conductive layer structure and/or the at least one electrically insulating layer structure of the stack. This may bring the advantage of giving the possibility of providing metallic nanostructures and/or microstructures without drastically increasing the total thickness of the stack. In an example, the thickness of the electrically insulating material and/or said chemical composition and/or said coating layer is smaller than 20 µm and/or smaller than 10% of the thickness of the electrically conductive layer structure and/or electrically insulating layer structure.

According to another embodiment of the invention, the electrically insulating material and/or said chemical composition and/or the coating covering the surface of said at least one second portion comprises a material being different than the material of the at least one electrically conductive layer structure and/or the at least one electrically insulating layer structure. This may bring the advantage of imparting different physical and/or chemical properties to the at least one second portion of the at least one electrically conductive layer structure. Thus the at least one second portion may react differently during at least one manufacturing step compared to the at least one electrically conductive layer structure and/or the at least one electrically insulating layer structure.

According to a preferred embodiment of the invention, said at least one first portion is free of said electrically insulating material and/or said chemical composition and/or said coating layer provided on said at least one second portion. This may bring the advantage of providing, in particular growing, the metallic nanostructures and/or microstructures on the at least one first portion more efficiently, since said electrically insulating material and/or said chemical composition and/or said coating layer is interfering, in particular preventing, the metallic nanostructures and/or microstructures from being provided on said at least one first portion.

According to a further embodiment of the invention, said electrically insulating material and/or said chemical composition and/or said coating layer is exclusively provided on said at least one second portion. Use of a surface treatment process step and/or a coating step may ensure providing the electrically insulating material and/or said chemical composition and/or said coating layer exclusively on said at least one second portion. Therefore, providing the metallic nanostructures and/or microstructures may be efficiently prevented at the at least one second portion.

According to another embodiment of the invention, the reflection of electromagnetic waves of said at least one first portion is different compared to the reflection of electromagnetic waves of said at least one second portion.

According to a preferred embodiment of the invention, the reflection of electromagnetic waves of said at least one first portion is higher compared to the reflection of electromagnetic waves of said at least one second portion. The electrically insulating material and/or said chemical composition and/or said coating layer covering the at least one second portion may influence the reflection of electromagnetic waves and thus the reflection of electromagnetic waves of said at least one first portion may be different compared to, in particular higher than, the reflection of electromagnetic waves of said at least one second portion. In an example, the electromagnetic waves may comprise waves for high frequency application and/ waves in between 300 nm to 1000 nm.

According to another embodiment of the invention, the metallic nanostructures and/or microstructures comprise nanowires, in particular metallic nanowires, and/or a micro- and/or nano-porous body, in particular nano-porous copper. In a preferred example, the nanostructures and/or microstructures, in particular the nanowires, may comprise or consist of copper. Nanowires can be easily grown on electrically conductive surfaces, in particular on a surface of an at least one first portion of the at least one electrically conductive layer structure. Nanowires may be very flexible and thus may be preferably used for connecting the at least one first portion to another electrically conductive layer structure and/or a component.

According to a further embodiment of the invention, a plurality, in particular the majority, of the metallic nanostructures and/or microstructures comprise an elongated shape. Due to the elongated shape, the metallic nanostructures and/or microstructures may preferably be used for a (vertical) interconnection toward different electrically conductive layer structures and/or components. Additionally or alternatively, due to the elongated shape, the nanostructures and/or microstructures may be bendable and thus may be deformed into a desired direction.

According to a preferred embodiment of the invention, an extremity of the metallic nanostructures and/or microstructures is connected to said at least one first portion. Preferably, the metallic nanostructures and/or microstructures may merge into/from the at least on first portion. In an example, the metallic nanostructures and/or microstructures may be monolithically grown at the at least one first portion of the at least one electrically conductive layer structure. Growing the metallic nanostructures and/or microstructures from the at least one first portion may bring the advantage of having a strong and reliable connection between the metallic nanostructures and/or microstructures and the at least one electrically conductive layer structure.

According to another embodiment of the invention, at least 80%, in particular at least 95%, of the surface of said at least one first portion is connected to the metallic nanostructures and/or microstructures. In an example, the metallic nanostructures and/or microstructures have a diameters smaller than 10 µm, in particular smaller than 500 nm, more than 100 metallic nanostructures and/or microstructures may be provided on the at least one first portion. Since more than 100 metallic nanostructures and/or microstructures are provided even a coverage of at least 80% of the surface of the at least one first portion with the metallic nanostructures and/or microstructures may provide a reliable mechanical and/or electrical connection between the nanostructures and/or microstructures and a further electrically conductive layer structure.

According to a further embodiment of the invention, the metallic nanostructures and/or microstructures are encircled by the (at least one) electrically insulating layer structure and/or by said electrically insulating material and/or by said chemical composition and/or by said coating layer. This may bring the advantage of protecting the metallic nanostructures and/or microstructures by the electrically insulating layer structure, in particular in a lateral direction, and/or of enlarging the planar extension of the metallic nanostructures and/or microstructures and/or the respective amount up to said electrically insulating material and/or by said chemical composition and/or by said coating layer. The protection may be related to mechanical influences, for example pressure and/or stress and/or scratches, and/or chemical influences, for example oxidation and/or UV radiation.

According to a preferred embodiment of the invention, the component carrier comprises at least two electrically conductive layer structures, in particular opposed one to each other. This may bring the advantage of creating component carriers having more complex and/or sophisticated electrically conductive layer structures designs.

In the context of the present document the term with "opposed" it is meant that the at least two electrically conductive layer structures are distanced one to each other without a further electrically conductive layer structure in between, in particular with at least one insulating layer structure in between, so that one main surface of one of the at least two electrically conductive layer structures faces one main surface of the other one of the at least two electrically conductive layer structures, more in particular at least partially in contact with the at least one insulating layer structure.

According to another embodiment of the invention, the component carrier comprises at least two sub-carriers, in particular at least a first sub-carrier and a second sub-carrier, each comprising at least one electrically conductive layer structure, wherein the at least two sub-carriers are stacked one above the other in thickness direction, in particular with the respective at least one electrically conductive layer structure of the first sub-carrier opposed to the at least one electrically conductive layer structure of the second sub-carrier. This may bring the advantage of simplifying the manufacturing of the component carrier by connection the at least two sub-carriers, in particular at their opposed main surfaces.

In the context of the current document, the term "sub-stack" may refer to a semifinished subassembly comprising at least one, in particular at least two, electrically conductive layer structures and at least one electrically insulating layer structure. In particular, the electrically insulating layer structure may be located such that, the main surface of the electrically insulating layer structure is in direct contact with the main surface of the electrically conductive layer structure. Preferably, the electrically insulating layer structure may be sandwiched between two adjacent electrically conductive layer structure regarding stacking direction. In comparison to the term sub-carrier, a sub-stack may comprise less layers and/or may not have at least a component embedded in and/or surface mounted on the sub-stack.

In the context of the present invention the term "sub-carrier" may in particular refer to a subassembly comprising a plurality, in particular at least three electrically conductive layer structure and a plurality, preferably at least two, electrically insulating layer structure, configured to be stacked with other layer structures to a stack of a component carrier according to the present invention. A sub-carrier may form a part of a layer structure or a complete layer within the stack. A sub-carrier may in particular have a specific function. A sub-carrier may, for example, support the main carrier function of the component carrier and may, for example, in particular mechanically strengthen the component carrier. A sub-carrier may in particular be a carrier having a plurality of electrically conductive layer structures and electrically insulating layer structures, wherein in particular at least one electrically insulating layer structure is stacked in between two electrically conductive layer structures in stacking direction, and wherein optionally one or more components can be embedded in the sub-carrier.

Alternatively, or in addition, sub-carrier may, for example, comprise the functionality of one or more processors, memories and/or antennas.

A component carrier according to the present invention may comprise a plurality of sub-carriers or sub-stacks, wherein in particular at least two sub-carriers may comprise or have different functionalities or are configured for different purposes. Thereby, a compact and advantageous component carrier may be provided comprising a widespread functionality.

According to another embodiment of the invention, the metallic nanostructures and/or microstructures are located on only one of said two opposed electrically conductive layer structures. This may bring the advantage of saving time and/or material during a process steps of providing metallic nanostructures and/or microstructures on the second of the at least two electrically conductive layer structures and/or the second of the at least two sub-carriers and thus may enhance the production speed of the component carrier, since it may be sufficient when the metallic nanostructures and/or microstructures are provided on one of the two electrically conductive layer structures and/or sub-carrier compared to providing the metallic nanostructures and/or microstructures on both of said two opposed electrically conductive layer structures.

According to a further embodiment of the invention, the metallic nanostructures and/or microstructures are configured to abut against the opposed electrically conductive layer structure. In an example, the majority or each of the metallic nanostructures and/or microstructures may deform against the opposed electrically conductive layer structure. This may bring the advantage of connecting the at least two electrically conductive layer structures and/or the at least two sub-carriers in a reliable way, since the opposed electrically conductive layer structure and/or the metallic nanostructures and/or microstructures may deform and thereby create mechanical fixation, when for example the metallic nanostructures and/or microstructures permeate into the opposed electrically conductive layer structure.

According to a preferred embodiment of the invention, each of the opposed electrically conductive layer structures comprise the respective first portion, in particular at least one further first portion, and second portions, in particular at least one further second portion. Preferably the respective second portion may comprise said electrically insulating material and/or said chemical composition and/or said coating layer. This may bring the advantage of bringing a higher functionality and/or more complex design to the component carrier, since the opposed electrically conductive layer structure is more complex in terms of appearance and/or architecture.

According to another embodiment of the invention, the metallic nanostructures and/or microstructures are provided on one of said two opposed electrically conductive layer structures and are configured to abut against the surface of the at least one (further) first portion of the opposed electrically conductive layer structure. This may bring the advantage of enabling a reliable mechanical and/or electrical connection in stacking direction. Especially for the electrical connection, a direct contact with an electrically conductive material and/or surface is required, which may be ensured by the contact of the metallic nanostructures and/or microstructures with the electrically conductive surface of the (respective) at least one (further) first portion. In an example, the other of said two opposed electrically conductive layer structures may be free from an at least one second portion. Since the metallic nanostructures and/or microstructures from the first electrically conductive layer structure of the two opposed electrically conductive layer structures are abutting the surface of the other opposed electrically conductive layer structure, a (further) first portion may be created at the (surface) position where the metallic nanostructures and/or microstructures are abutting the other opposed electrically conductive layer structure.

According to a further embodiment of the invention, the metallic nanostructures and/or microstructures are provided on the at least one first portion of each the two opposed electrically conductive layer structures. Preferably, the metallic nanostructures and/or microstructures may be provided on the at least one first portion of each the two opposed electrically conductive layer structures, wherein the first sub-carrier comprises one of the two opposed electrically conductive layer structures and the second sub-carrier comprises the other of the two opposed electrically conductive layer structures. Growing of metallic nanostructures and/or microstructures may be easily done by the provided method. Furthermore, since the metallic nanostructures and/or microstructures may be provided in parallel on the two opposed electrically conductive layer structures, in particular the two sub-carrier, the production time of the component carrier is decreased.

According to a preferred embodiment of the invention, the metallic nanostructures and/or microstructures are nanowires intermingled one to each other. Preferably, the metallic nanostructures and/or microstructures provided on the at least one first portion of one of the two opposed electrically conductive layer structures, in particular of the first sub-carrier, may intermingle with the metallic nanostructures and/or microstructures provided on the respective at least further first portion of the other one of the two opposed electrically conductive layer structures, in particular of the second sub-carrier. This may bring the advantage that intermingling the metallic nanostructures and/or microstructure with each other may modify mechanical properties, for example increase the tensile strength, of the metallic nanostructures and/or microstructures, compared to forming a rope out of single strands, maintaining at the same time a suitable contact surface to allow the necessary current passage between the two opposed electrically conductive layer structures without suffering of drawbacks resulting from reduced cross section, such as overheating.

According to another embodiment of the invention, the at least one first portion and/or the at least one second portion of the respective electrically conductive layer structure at least partially overlaps with the respective first portion and/or said second portion of the opposed electrically conductive layer structure. Preferably, the at least one first portion and/or the at least one second portion of the respective electrically conductive layer structure provided on the first sub-carrier may at least partially overlap with the respective first portion and/or said second portion of the opposed electrically conductive layer structure provided on the second sub-carrier. This may bring the advantage of enabling a higher tolerance in terms of lateral shift between the different layers of the stack during manufacturing of the component carrier, since a plurality, in particular at least 100, of metallic nanostructures and/or microstructures still ensures a reliable mechanical and/or electrical connection between the two opposed electrically conductive layer structures. Preferably, a forest of metallic nanowires provided on one or two of the respective at least one first portion(s) having an elongated shape with an aspect ratio greater than 5, in particular greater than 10, may assure a reliable electrical connection even if the opposed electrically conductive layer structures are not aligned one to each other.

According to a further embodiment of the invention, the at least one second portion of the respective electrically conductive layer structure at least partially overlapped the respective one second portion of the opposed electrically conductive layer structure are configured to create a (double plate) condenser. This may bring the advantage of imparting a functionality to the component carrier without embedding and/or surface mounting a component since the overlapped respective second portions create the functionality of the condenser.

According to a preferred embodiment of the invention, the vertical distance between the two opposed first portions is different than the vertical distance between the two opposed second portions. This may be a fingerprint feature of the applied method, since said electrically insulating material and/or said chemical composition and/or said coating layer is provided on the at least one second portion, in particular the two opposed second portions thereby decreasing the distance between the two opposed at least one second portions compared to the distance between the two opposed at least one first portions.

According to a further embodiment of the invention, a plurality among the first or the second portions of one of the two opposed electrically conductive layer structures at least partially overlaps one (common) respective first or second portion of the other one of the opposed electrically conductive layer structures. This may bring the advantage of implementing a more complex design of the at least one electrically conductive layer structures into the component carrier. Additionally or alternatively, this may give the advantage of having a stack comprising different structures of the respective at least two electrically conductive layer structures.

According to another embodiment of the invention, the at least one first portion and/or the at least one second portion of the opposed electrically conductive layer structures have different planar extension one to each other, in particular with respect to the portions of the same electrically conductive layer structure or with respect to those belonging to the opposed electrically conductive layer structures, more in particular those at least partially overlapping along the stack thickness direction. A reliable connection between the opposed electrically conductive layer structure by the metallic nanostructures and/or microstructures may be established even if the planar extension of the opposed electrically conductive layer structures, in particular the opposed at least one first portions, are different. Preferably, a forest of metallic nanowires provided on one or two of the respective at least one first portion(s) having an elongated shape with an aspect ratio greater than 5, in particular greater than 10, may assure a reliable electrical connection even if the opposed electrically conductive layer structures are not aligned one to each other.

According to a preferred embodiment of the invention, the opposed first portions have the same electrical function. Preferably, the opposed first portions at least those at least partially planarly overlapping may have the same electrical function. For example, an electrical function may be a transmission of signals, in particular voltage and/or radio frequency, and/or power, for example electric current, and/or ground signals. This may bring the advantage of having an efficient and easy routing of electrical functions inside the component carrier.

In the content of the current document, the term "at least planarly overlapping" may refer to a spatial alignment of two bodies, in particular their surfaces. Thereby the (perpendicularly projected) area of the first body may not be congruent with the (perpendicularly projected) area of the second body, when considering a spatial direction. However, at least a portion of the (perpendicularly projected) area of the first body has to be part of the same area of at least a portion of the (perpendicularly projected) area of the second body, when considering a spatial direction. In an example when two bodies are transversally shifted with respect to each other in a direction, they may be at least planarly overlapping. In a specific example, two electrically conductive layer structures of a component carrier may be at least planarly overlapping, when they are located in different vertical levels considering stacking direction and are (eventually partially) laterally shifted with respect to each other.

According to another embodiment of the invention, the amount of the first and/or second portions of one of the two opposed electrically conductive layer structures is different than or is the same as the respective amount the first and/or second portions of the opposed electrically conductive layer structures. This may bring the advantage of providing metallic nanostructures and/or microstructures using the described methods at the first portions (of the opposed electrically conductive layer structures) while being not restricted to the specific amount of the first portions. This may simplify the component carrier production.

According to a further embodiment of the invention, at least one distancing element is located between the at least two opposed electrically conductive layer structures and/or the at least two opposed electrically insulating layer structures.

According to a preferred embodiment of the invention, the distancing element is a pillar. Additionally or alternatively, the distancing element may be an active component and/or a passive component and/or may be a three-dimension body having a shape different to a pillar, for example a cube and/or a cone and/or a pyramid and/or an irregular shape. This may bring the advantage that the use of a distancing element, in particular a pillar and/or a passive component, may assist to achieve a precise distancing between the two opposed electrically conductive layer structures and/or the at least two opposed electrically insulating layer structures, even considering the randomly deformation of the metallic nanostructures and/or microstructures for the proper electrical connection during stacking the respective layers of the stack and eventually during the lamination of the stack where temperature, and eventually pressure, are applied. In an example, the distancing element may be an electrically insulating body. In another example, the distancing element may be an electrically conductive body.

According to a further embodiment of the invention, a protecting material is located between the two opposed first portions.

According to another embodiment of the invention, the protecting material comprises an underfilling material. In an example, the underfilling material may comprise a polymeric material, in particular an organic polymeric material, for example an epoxy resin. Additionally and/or alternatively, the protecting material may comprise a surface finish, for example Ni or Au. This may bring the advantage of protecting the at least one electrically conductive layer structure and/or the at least one first portion and/or the at least one second portion from environmental influences, for example scratches and/or moisture and/or oxygen. On the other hand, the second portions may be protected by the electrically insulating material and/or said chemical composition and/or said coating layer.

According to a preferred embodiment if the invention, the method of manufacturing the component carrier comprises performing a surface treatment process step and/or a coating step on said at least one second portion. This may bring the advantage of dividing the at least one electrically conductive layer structure into the at least one first portion and the at least one second portion in an easy and reliable way by using well-known and established manufacturing processes in the field of component carrier production. Additionally or alternatively, this may manipulate the surface properties, in particular the electrically conductivity, of the at least one electrically conductive layer structure such, that the at least one first portion has a higher conductivity compared with the at least one second portion in an efficient way.

According to another embodiment of the invention, the method of manufacturing the component carrier, in particular the surface treatment process step, comprises and oxidation step. Oxidizing the surface of the at least one electrically conductive layer structures and thereby creating the at least one second portion can be done in an easy way. Thereby an oxidation layer comprising a metal salt is provided on the exposed main surface and/or at least a portion of a sidewall of the electrically conductive layer structure. Additionally or alternatively, the oxidation step may chemically bind an electrically insulating material to the at least one second portion.

According to a further embodiment of the invention, the method of manufacturing the component carrier, in particular the surface treatment process step and/or coating step, comprises a printing process step, in particular screen printing and/or laser assisted printing step. The laser assisted printing process may comprise applying and structuring a photo imageable dielectric. This may bring the advantage that the at least one second portion is covered and thereby protected from the influences of the environment. Additionally or alternatively, the printing process step may prevent growing of the metallic nanostructures and/or microstructure on the at least one second portion in a reliable way.

According to a preferred embodiment of the invention, the method of manufacturing the component carrier comprises applying a liquid photo resist on the surface of said at least one second portion. Additionally, the method of manufacturing the component carrier comprises applying a liquid photo resist on the surface of said at least one first portion. During manufacturing the component carrier, the liquid photo resist may be structured and removed from the at least one first portion. This may bring the advantage that the liquid photo resist may be resistant towards other process steps, in particular wet-chemical process steps, and thus may ensure dividing the at least one electrically conductive layer structure into at least one first portion and at least one second portion and/or providing the metallic nanostructures and/or microstructures (on the at least one first portion only) in a reliable way.

According to another embodiment of the invention, the method of manufacturing the component carrier comprises providing metallic nanostructures and/or microstructures on said first portion comprises growing the metallic nanostructures and/or microstructures from said at least one first portion. Preferably, the metallic nanostructures and/or microstructures may be provided on said first portion only. This may bring the advantage of providing the metallic nanostructures and/or microstructures on dedicated portions of the at least one electrically conductive layer structure only.

According to a preferred embodiment of the invention, the method of manufacturing the component carrier comprises dividing at least one surface of said at least one electrically conductive layer structure into at least one first portion and at least one second portion comprises the step of performing the surface treatment process step and/or the coating step to said second portion only. This may simplify the manufacturing steps of the manufacturing the component carrier. Additionally or alternatively, this may influence, in particular prevent, the growing of metallic nanostructures and/or microstructures on the at least one second portion.

The preferred embodiments presented with reference to a component carrier according to the first aspect of the present invention and its advantages apply correspondingly to a method according to the second aspect of the present invention.

Further features of the invention are shown in the claims, the figures, and the description of the figures. All the features and combinations of features mentioned above in the description as well as the features and combinations of features mentioned below in the description of the figures and/or shown alone or in combination in the figures can be used not only in the combination as indicated or shown in each case, but also in other combinations or on their own so far it can technically be realized.
Figure 1 illustrates a cross-sectional view of a component carrier according to an exemplary embodiment.
Figure 2 illustrates cross-sectional view of another component carrier according to an exemplary embodiment.
Figure 3a to Figure 3e illustrate cross-sectional views of structures obtained during carrying out a method of manufacturing a component carrier according to an exemplary embodiment of the invention.
Figure 4a to Figure 4b illustrate cross-sectional views of structures of a first variant when continuing from Figure 3e obtained during carrying out a method of manufacturing a component carrier, shown in Figure 1, according to an exemplary embodiment of the invention.
Figure 5a to Figure 5b illustrate cross-sectional views of structures of a second variant when continuing from Figure 3e obtained during carrying out a method of manufacturing a component carrier, shown in Figure 1, according to an exemplary embodiment of the invention.
Figure 6a to Figure 6d illustrate cross-sectional views of structures obtained during carrying out another method of manufacturing a component carrier, shown in Figure 1, according to another exemplary embodiment of the invention.
Figure 7a to Figure 7e illustrate cross-sectional views of structures obtained during carrying out a further method of manufacturing a component carrier, shown in Figure 1, according to a further exemplary embodiment of the invention.
Figure 8a illustrates a cross-sectional view of a micro- and/or nano-porous body, according to an exemplary embodiment of the invention.
Figure 8b illustrates a cross-sectional view of a component carrier comprising an electrically conductive layer structures having a surface with a first portion, wherein metallic nanostructures and/or microstructures are provided on said first portion.
Figure 8c illustrates a cross-sectional view of a component carrier comprising a stack comprising two adjacent electrically conductive layer structures. Each of the electrically conductive layer structures comprises a surface with a first portion, wherein metallic nanostructures and/or microstructures are provided on said first portion. The respective metallic nanostructures and/or microstructures are in direct contact and intermingled with each other.

### Detailed Description

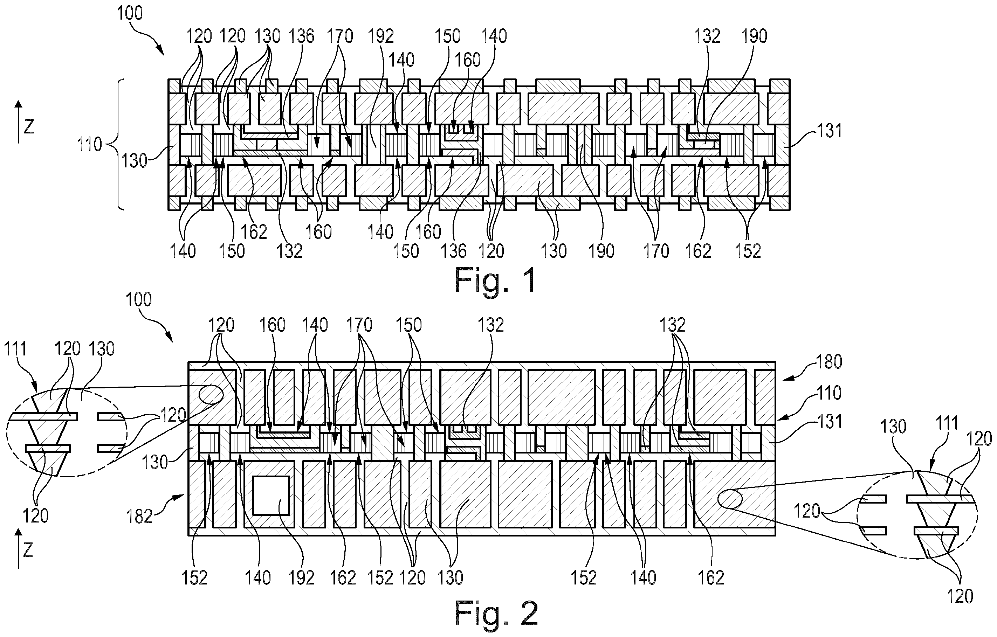

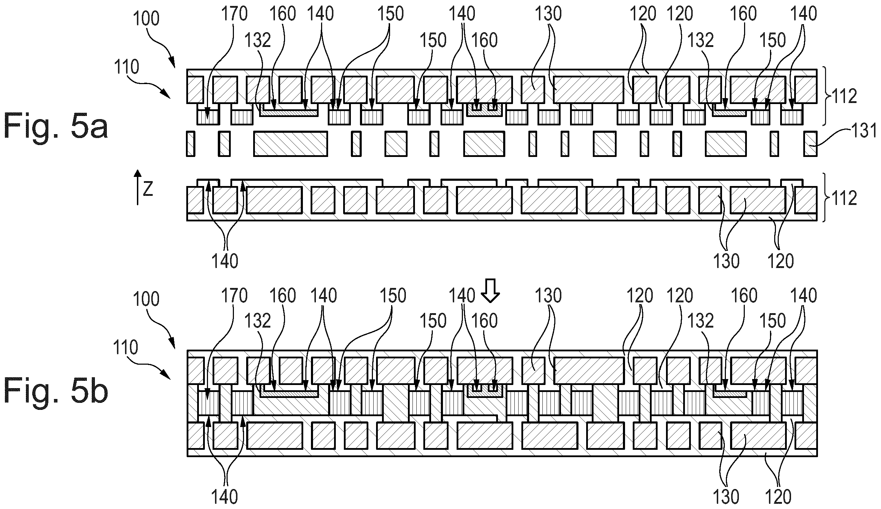

Figure 1 shows an example of a component carrier 100 according to the first aspect of the present invention. The component carrier 100 comprises a stack 110 comprising at least one electrically conductive layer structure 120 and at least one electrically insulating layer structure 130. Preferably, the at least one electrically conductive layer structure 120 and at least one the electrically insulating layer structure 130 may be aligned one above each other in stacking direction Z, which is perpendicular with respect to the main extension direction of the component carrier 100, in order to create a stack 110. In an example, the stack 110 may comprise a plurality of electrically conductive layer structures 120 and/or a plurality of electrically insulating layer structures 130 (alternatingly) aligned one above the other regarding stacking direction Z. Preferably, the electrically conductive layer structure 120 may comprise copper, whereas the electrically insulating layer structure 130 may comprise an organic polymer, for example epoxy resin. At least one surface 140 of said at least one electrically conductive layer structure is divided in at least one first portion 150 and at least one second portion 160. Said at least one first portion 150 and said at least one second portion 160 are adjacent one to the other and the at least one first portion 150 has a higher conductivity with respect to that of the at least one second portion 160, wherein on said at least one first portion 150 metallic nanostructures and/or micro structures 170, in the specific embodiment a plurality of nanowires 170, are provided. Preferably, the at least one electrically conductive layer structure 120 may be located at one of the two main surfaces of the component carrier 100. In an example, the electrical conductivity and/or the thermal conductive of said at least one first portion 150 may be higher than that of the at least second portion 160. In another example, the at least one first portion 150 may have different other physical properties, for example roughness and/or surface energy and/or dielectric constant, compared to the at least one second portion 160. Due to the physical properties, especially the electrically conductivity, (copper) nanowires 170 are provided on the surface of and/or at the first portion 150. Without the division of the at least one electrically conductive layer structure 120 in at least one first portion 150 and at least one second portion 160, (copper) nanowires 170 may be provided to an electrically conductive layer structure 120 without any control at which position the (copper) nanowires are located. Due to the division of the surface 140 of the electrically conductive layer structure into the at least one first portion 150 and the at least one second portion 160, (copper) nanowires 170 are provided at at least one dedicated surface 140 of an electrically conductive layer structure 120. Optionally, the exposed electrically conductive layer structure 120 of the stack 110 may comprise a surface finish, for example comprising gold and/or nickel and/or palladium, and/or the exposed electrically insulating layer structure 130 of the stack 110 may comprise a solder resist. In the shown example, the at least one electrically conductive layer structure 120 may comprise a pad and/or a trace, preferably a copper pad and/or a copper trace, wherein the surface 140 of said (copper) pad and/or (copper) trace is divided into the at least one first portion 150 and the at least one second portion 160. In particular, one (copper) trace or (copper) pad may comprise the at least one first portion 150 and the at least one second portion 160 being adjacent one to the other. Alternatively, one (copper) pad or one (copper) trace may comprise the at least one first portion 150 and another (copper) pad or another (copper) trace may comprise the at least one second portion 160. In a further example, the at least one first portion 150 may be laterally shifted relative to the at least one second portion 160 and thereby having a common interface. In other words, the at least one first portion 150 and the at least one second portion 160 may be in direct contact with each other. Additionally or alternatively, the at least one first portion 150 and the at least one second portion 160 may be laterally shifted such that they are not in direct contact with each other. In an alternative not shown embodiment, an electrically insulating material is provided, said electrically insulating material covering said at least one second portion 160. According to the shown embodiment of the invention, a chemical composition 132, in particular a metal salt, more in particular a metal oxide or a metal nitride, for example copper oxide and/or silver oxide and/or copper nitride and/or silver nitride, is provided, said chemical composition 132 covering said at least one second portion 160. Additionally or alternatively, the metal salt may comprise a metal chloride and/or a metal sulfate and/or a metal nitrite, for example copper chloride and/or copper sulfate and/or copper nitrite. In an example, the electrically insulating material may comprise the chemical composition 132. According to the shown embodiment, a coating layer 136 is provided, said coating layer 136 covering said at least one second portion 160. In an example, the electrically insulating material may comprise a coating layer 136 (in addition or alternatively to the chemical composition 132). In an example, the coating layer 136 may comprise polymeric material, in particular an organic polymeric material, for example an epoxy resin and/or a poly (meth)acrylate and/or polyimide. Preferably, the electrically insulating material and/or the coating layer 136 and/or the chemical composition 132 may be located at the main surface of the electrically conductive layer structure 120. Additionally or alternatively the electrically insulating material and/or the coating layer 136 and/or the chemical composition 132 may be located at the surface of at least one side wall of the electrically conductive layer structure 120. This may bring the advantage of selectively providing metallic nanostructures and/or microstructures 170 at the at least one first portion 150 since the insulating material and/or the coating layer 136 and/or the chemical composition 132 provided on the surface 140 of the at least one second portion 160 may prevent the (copper) nanowires 170 from growing. The (copper) nanowires 170 may be physical structures with dimensions in the range of nanometers to micrometers, in particular having dimensions in a range between 0.1 nm and 10 micrometers. Preferably, the (copper) nanowires 170 may have dimensions in a range between 1 nm and 500 nm. Additionally or alternatively, the metallic nanostructures and/or microstructures 170 may comprise at least 100, in particular at least 1000, individual nanostructures and/or microstructures, in particular nanowires. Preferably, the nanowires 170 may comprise or consist of copper. Alternatively, nanowires 170 may comprise a metal being different from copper, for example nickel, silver, titanium, chromium or cobalt. In another example, the (copper) nanowires 170 may have an elongated shape and/or may have a cylindrical shape with an axial dimension being at least 5 times, in particular at least 10 times, larger than their respective radial dimension. Alternatively, the metallic nanostructures and/or microstructures 170 may comprise nano-porous copper. As can be seen in Figure 1, the electrically insulating material and/or the coating layer 136 and/or chemical composition 132 may be located, in particular sandwiched, between said at least one second portion 160 and the at least one electrically insulating layer structure 130. Additionally or alternatively, the electrically insulating material and/or the coating layer 136 and/or chemical composition 132 may be in direct contact with the electrically conductive layer structure 120 and the electrically insulating layer structure 130. Furthermore, the (copper) nanowires 170 may be in direct contact with the at least one electrically conductive layer structure 120. Preferably, the (copper) nanowires 170 may be in direct contact with the at least one electrically conductive layer structure 120 which is located at at least one of the two main surfaces of the component carrier 100. In an example, an extremity of the (copper) nanowires 170 may be connected to the at least one first portion 150. Additionally, (copper) nanowires 170 may be in direct contact with said electrically insulating material and/or said chemical composition 132 and/or said coating layer 136 provided on of said at least one second portion 160. Since a method is used growing the (copper) nanowires 170 directly from/on the at least first portion 150, the (copper) nanowires may have a good mechanical connection to the at least one electrically conductive layer structure 120. In a further example, the (copper) nanowires 170, in particular the lateral surface of the (copper) nanowires 170, may be in direct contact with the electrically insulating layer structure 130 and/or a protecting material 131, in the specific embodiment a underfilling material. Preferably, the electrically insulating material and/or said chemical composition 132 and/or said coating layer 136 covering the surface 140 of said at least one second portion 160 may comprise a thickness being different, in particular lower, than the thickness of the at least one electrically conductive layer structure 120 and/or the at least one electrically insulating layer structure 130 of the stack 110. In an example, the thickness of the electrically insulating material and/or said chemical composition 132 and/or said coating layer 136 may be in the range from 0.1 µm to 25 µm, in particular in the range from 2 µm to 15 µm. In comparison to that, the thickness of the electrically insulating layer structure 130 and/or electrically conductive layer structure 120 may be in the range from 5 µm to 300 µm. Alternatively, the thickness of the insulating material and/or said chemical composition 132 and/or said coating layer 136 may be smaller than 10%, in particular 20%, than the thickness of the electrically conductive layer structure 120 and/or electrically insulating layer structure 130. In a further example, the thickness of the chemical composition 132, in particular a metal salt, more in particular copper oxide, may be in the range from 100 nm to 500 nm. In comparison, the thickness of the electrically insulating layer structure 130 and/or the underfilling material 131 may be in the range from 5 µm to 300 µm and/or the thickness of the electrically conductive layer structure 120 may be in the range from 2 µm and 20 µm. In another example, the thickness of the electrically insulating material and/or coating layer 136, for example a photo imageable material, may be in the range from 1 µm to 10 µm. In comparison, the electrically insulating layer structure 130 and/or the underfilling material 131 may be in the range from 15 µm to 300 µm. Still in another example, the sum of the thickness of the electrically conductive layer structure 120 and the (copper) nanowires 170 and the electrically insulating material or said chemical composition 132 or the coating layer 136 may be substantially the same as the thickness of the underfilling material 131. This may bring the advantage of modifying the surface 140 of the at least one electrically conductive layer structure 120 without increasing the overall thickness of the component carrier 100 to a large extend. Preferably, the material of the electrically insulating material and/or said chemical composition 132 and/or the coating layer 136 covering the surface of said at least one second portion 160 may be different to the material of the of the at least one electrically conductive layer structure 120 and/or the at least one electrically insulating layer structure 130. Additionally or alternatively, the material of the electrically insulating material and/or said chemical composition 132 and/or the coating layer 136 covering the surface of said at least one second portion 160 may be similar to the material of the of the at least one electrically conductive layer structure 120 and/or the at least one electrically insulating layer structure 130. In an example, the material of at least one the electrically conductive layer structures 120 may consist of copper, whereas the material of the chemical composition 132 may comprise a metal salt, in particular copper oxide. Since copper oxide comprises electrically insulating properties and metallic copper comprises electrically conductive properties, the two materials shall be considered as different materials even if they comprise the same element, in this case copper. Thus (copper) nanowires 170 may grow on a metallic copper surface, whereas the (copper) nanowires 170 may not grow on a copper oxide surface, since the copper oxide is resistant to the conditions under which the nanostructures are applied. Preferably, the component carrier 100 may comprise at least two electrically conductive layer structures 120 opposed one to each other. In an example, one of the at least two electrically conductive layer structures 120 may be divided in an at least one first portion 150 and an at least one second portion 160. The other one of the least two electrically conductive layer structures 120 may be free from a division into an at least one first portion 150 and an at least one second portion 160. In another example, each of the at least two electrically conductive layer structures 120 may be divided in a respective at least one first portion 150 and a respective at least one second portion 160. In an example the component carrier 100 may comprise a stack 110 having an arrangement that the at least one electrically insulating layer structure 130 and/or an underfilling material 131 is sandwiched regarding stacking direction Z between the two adjacent electrically conductive layer structures 120. The reflection of electromagnetic waves of said at least one first portion 150 is different, in particular higher, compared to the reflection of electromagnetic waves of said at least one second portion 160. In an example, the electromagnetic waves may comprise waves for high frequency application and/or waves in between 300 nm to 1000 nm. The electrically insulating material and/or said chemical composition 132 and/or said coating layer 136 covering the at least one second portion 160 may influence the reflection of electromagnetic waves and thus the reflection of electromagnetic waves of said at least one first portion 150 may be different, in particular higher than, compared to the reflection of electromagnetic waves of said at least one second portion 160. In a preferred example, the at least one first portion 150 may free of said electrically insulating material and/or said chemical composition 132 and/or said coating layer 136. Additionally or alternatively, said electrically insulating material and/or said chemical composition 132 and/or said coating layer 136 may be exclusively provided on said at least one second portion 160. In a preferred example, at least 80%, in particular at least 95%, of the surface 140 of said at least one first portion 150 may be connected to the (copper) nanowires 170. Alternatively, at least 60% of the surface 140 of said at least one first portion 150 may be connected to the (copper) nanowires 170. Since a plurality, in particular more than 100, of (copper) nanowires 170 are provided, even a coverage of at least 60% of the surface 140 of the at least one first portion 150 with the (copper) nanowires 170 may ensure a reliable mechanical and/or electrical connection between the nanostructures and/or microstructures 170 and a further electrically conductive layer structure 120. In another preferred perspective, the (copper) nanowires 170 may be encircled by the (at least one) electrically insulating layer structure 130 and/or the underfilling material 131 and/or by said electrically insulating material and/or by said chemical composition 132 and/or by said coating layer 136. This may bring the advantage of defining where the (copper) nanowires 170 shall be provided in a precise way, since the surface 140 of the first portion 150 is circumferentially closed by the (at least one) electrically insulating layer structure 130 and/or the underfilling material 131 and/or by said electrically insulating material and/or by said chemical composition 132 and/or by said coating layer 136. A plurality of the (copper) nanowires 170 may be encircled by the same (at least one) electrically insulating layer structure 130 and/or by said electrically insulating material and/or by said chemical composition 132 and/or by said coating layer 136. In another example, the (copper) nanowires 170 may be provided on one of said two opposed electrically conductive layer structures 120 and are configured to abut against the surface of the at least one (further) first portion 150, 152 of the opposed electrically conductive layer structure (see Figure 5a, Figure 5b). In a further example, each of the opposed electrically conductive layer structures 120 may comprise the respective first portion 150, in particular at least one further first portion 152, and second portions 160, in particular at least one further second portion 162. Preferably the respective second portion 160, in particular the at least one further second portion 162, may comprise said electrically insulating material and/or said chemical composition 132 and/or said coating layer 136. This may enable to provide (copper) nanowires 170 on the at least one further first portion 152 of the opposed electrically conductive layer structure 120 too. Further preferably, the (copper) nanowires 170 may be provided on the at least one (further) first portion 150, 152 of each the two opposed electrically conductive layer structures 120. Thereby, the (copper) nanowires 170 may intermingle one to each other resulting in a reliable mechanical interconnection between the two opposed electrically conductive layer structures 120. In a further example, the at least one first portion 150 and/or the at least one second portion 160 of the respective electrically conductive layer structure 120 at least partially overlaps with the respective (further) first portion 150, 152 and/or said (further) second portion 160, 162 of the opposed electrically conductive layer structure 120. Preferably, the at least one second portion 160 of the respective electrically conductive layer structure 120 at least partially overlapped the respective (further) second portion 160, 162 of the opposed electrically conductive layer structure 120 may be configured to create a (double plate) condenser. The condenser may have a capacitance smaller than 1 mF, in particular in the range from 1 pF to 500 µF, more in particular in the range from 1 pF to 500 nF. This may bring the advantage of powering components 192 having a small power consumption associated to the component carrier 100. In a further example, the vertical distance between the two opposed first portions 150, 152 may be different than the vertical distance between the two opposed second portions 160, 162. Alternatively, the vertical distance between the two opposed first portions 150, 152 may be similar, in particular the same, as the vertical distance between the two opposed second portions 160, 162. Since the distance between the two opposed second portions 160, 162 may be smaller than the distance between the two opposed first portions, 150, 152, this may intrinsically include that at least a portion of the (copper) nanowires 170 is (laterally) protected due to the thickness of the electrically insulating material and/or said chemical composition 132 and/or said coating layer 136 provided on the two opposed second portion 160, 162. In another example, a plurality among the first portions 150 or the second portions 160 of one of the two opposed electrically conductive layer structures 120 may at least partially overlap one (common) respective (further) first portion 150, 152 or one (common) respective (further) second portion 160, 162 of the other one of the opposed electrically conductive layer structures 120. Additionally or alternatively, a first portion 150 of the electrically conductive layer structures 120 may overlap one respective (further) first portion 150, 152 of the opposed other electrically conductive layer structure 120 and/or a second portion 160 of the electrically conductive layer structures 120 may overlap one respective (further) second portion 160, 162 of the opposed other electrically conductive layer structure 120. In another example, the at least one first portion 150 and/or the at least one second portion 160 of the opposed electrically conductive layer structures 120 may have different planar extension one to each other, in particular with respect to the portions of the same electrically conductive layer structure 120 or with respect to those belonging to the opposed electrically conductive layer structures 120, more in particular those at least partially overlapping along the stack thickness direction Z. Alternatively, the at least one first portion 150 and/or the at least one second portion 160 of the opposed electrically conductive layer structures 120 may have similar, in particular the same, planar extension one to each other, in particular with respect to the portions of the same electrically conductive layer structure 120 or with respect to those belonging to the opposed electrically conductive layer structures 120, more in particular those at least partially overlapping along the stack thickness direction Z. This may compensate possible misalignments of the two opposed electrically conductive layer structures 120, since the two opposed first portions 150, 152 and/or second portions 160, 162 may sufficiently overlap each other. In a preferred example, the opposed first portions 150, 152 may have the same electrical function. Preferably, the opposed first portions at least those at least partially planarly overlapping may have the same electrical function. In an example, an electrical function may include, power, ground, or signal. Alternatively, the opposed first portions 150, 152 may have different electrical functions. In another example, the amount of the first portions 150 and/or second portions 160 of one of the two opposed electrically conductive layer structures 120 may be different than or is the same as the respective amount the (further) first portions 150, 152 and/or (further) second portions 160, 162 of the opposed electrically conductive layer structures 120. Still in another example, a distancing element 190 may be located between the at least two opposed electrically conductive layer structures 120, in particular between the opposed second portions 160, 162, and/or the at least two opposed electrically insulating layer structures 130. In an example, the distancing element 190 may comprise electrically conductive material or electrically insulating material. Additionally or alternatively, the distancing element 190 may comprise a shape as a pillar, a cube, a cone, a pyramid or an irregular shape. Further additionally or alternatively, the distancing element 190 may be a component 192. In a preferred example, in the same vertical level of the stack 110 regarding stacking direction Z, the electrically insulating material and/or said chemical composition 132 and/or said coating layer 136 may be located. Additionally or alternatively, the electrically insulating material and/or said chemical composition 132 and/or said coating layer 136 may be in contact with the same electrically conductive layer structure 120, in particular at the same surface 140. This may simplify the manufacturing process and thus may enable a production of a component carrier 100 having a complex design. In another example, at least two electrically conductive layer structures 120 may be vertically interconnected by (metal filled) through connections. For example, the through connections may be mechanical and/or laser processed through holes, which are at least partially filled, preferably fully filled by electrically conductive material, in particular copper. This may bring the advantage of mechanically and/or electrically interconnect two (adjacent) electrically conductive layer structures 120.

Figure 2 shows a further example of a component carrier 100 according to the first aspect of the present invention. The component carrier 100 comprises a stack 110 comprising a first sub-carrier 180 and a second sub-carrier 182. As can be seen by the zoom of the stack 111, each of the two sub-carrier 180, 182 comprises a respective plurality of electrically conductive layer structures 120 and at least one electrically insulating layer structure 130. Optionally, it may be possible that the component carrier according to Figure 1 comprises a first sub-carrier 180 and a second sub-carrier 182. Again referring to Figure 2, the respective different electrically conductive layer structures 120 of each sub-carrier 180, 182 may be interconnected in stacking direction Z by vertical through connections. Said vertical through connections may be fully metalized structures, for example consisting of copper, and/or may comprise paste material, for example a solder paste and/or sinter paste. The respective sub-carrier 180, 182 may comprise an embedded and/or surface mounted component 192. Preferably, a first sub-carrier 180 may comprise at least one electrically conductive layer structure 120 being exposed at one main surface of the first sub-carrier 180, wherein at least one surface 140 of said exposed at least one electrically conductive layer structure 120 is divided in at least one first portion 150 and at least one second portion 160, said at least one first portion 150 and said at least one second portion 160 being adjacent one to the other, said at least one first portion 150 having a higher conductivity with respect to that of said at least one second portion 160, wherein on said at least one first portion 150 (copper) nanowires 170 are provided. Moreover, a second sub-carrier 182 may comprise at least one electrically conductive layer structure 120 being exposed at one main surface of the second sub-carrier 182, wherein at least one surface 140 of said exposed at least one electrically conductive layer structure 120 is divided in at least one further first portion 152 and at least one further second portion 162, said at least one further first portion 152 and said at least one further second portion 162 being adjacent one to the other, said at least one further first portion 152 having a higher conductivity with respect to that of said at least one further second portion 162, wherein on said at least one further first portion 152 (copper) nanowires 170 are provided. Additionally or alternatively, the respective sub-carrier 180, 182 may comprise at least one electrically conductive layer structure 120 being located in the inner volume of the sub-carrier 180, for example as shown in the zoom of the stack 111, wherein at least one surface 140 of said at least one electrically conductive layer structure 120 is divided in at least one (further) first portion 150, 152 and at least one (further) second portion 160, 162, said at least one (further) first portion 150, 152 and said at least one (further) second portion 160, 162 being adjacent one to the other, said at least one (further) first portion 150, 152 having a higher conductivity with respect to that of said at least one (further) second portion 160, 162, wherein on said at least one (further) first portion 150, 152 (copper) nanowires 170 are provided. A chemical composition 132 may cover the at least one second portion 160 of the first sub-carrier 180 and/or the at least one further second portion 162 of the second sub-carrier 182. Additionally or alternatively, an electrically insulating material or a coating layer 136 may be provided at the at least one second portion 160 and/or the at least one further second portion 162. The respective sub-carrier 180, 182 may comprise different amount of electrically conductive layer structures 120 and/or copper density distribution and/or components 192 embedded in and/or surface mounted on the stack 110 compared one to the other. Furthermore, the respective sub-carrier 180, 182 may be semi-finished component carrier, which are pre-manufactured. Preferably, the first sub-carrier 180 and the second sub-carrier 182 may be located such that, the first sub-carrier 180 comprising the (exposed) at least one electrically conductive layer structure 120 comprising the at least one first portion 150 with the (copper) nanowires 170 provided on is facing the second sub-carrier 182 comprising the (exposed) at least one electrically conductive layer structure 120 comprising the at least one further first portion 152 with the (copper) nanowires 170 provided on. Alternatively, the first sub-carrier 180 and the second sub-carrier 182 may be located such, that the first sub-carrier 180 comprising the (exposed) at least one electrically conductive layer structure 120 comprising the at least one first portion 150 with the (copper) nanowires 170 provided on is facing the second sub-carrier 182 comprising an (exposed) at least one electrically conductive layer structure 120 being free from (copper) nanowires 170. In another example, the component carrier 100 may comprise a stack 110 comprising at least two sub-carrier 180, 182 and having an arrangement that the at least one electrically insulating layer structure 130 and/or an underfilling material 131 is sandwiched regarding stacking direction Z between the two adjacent sub-carrier 180, 182. Preferably, the (copper) nanowires 170 may be provided on the at least one (further) first portion 150, 152 of each the two opposed electrically conductive layer structures 120, in particular different sub-carrier 180, 182. Thereby, the (copper) nanowires 170 may intermingle one to each other resulting in a reliable mechanical interconnection between the two opposed electrically conductive layer structures 120 of the different sub-carriers 180, 182. Preferably, the at least one first portion 150 and/or the at least one second portion 160 of the respective electrically conductive layer structure 120 provided on the first sub-carrier 180 may at least partially overlap with the respective (further) first portion 150, 152 and/or said (further) second portion 160, 162 of the opposed electrically conductive layer structure 120 provided on the second sub-carrier 182.

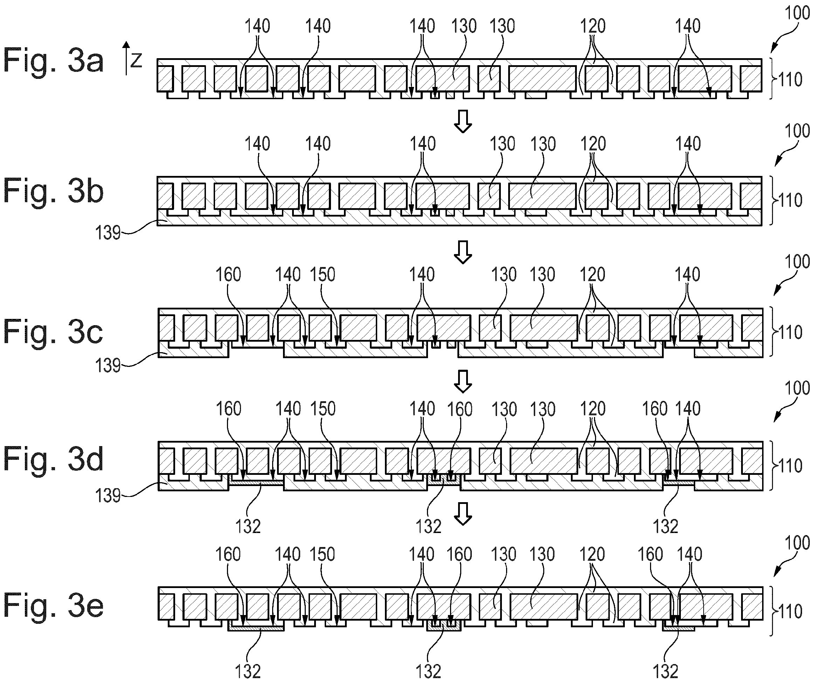

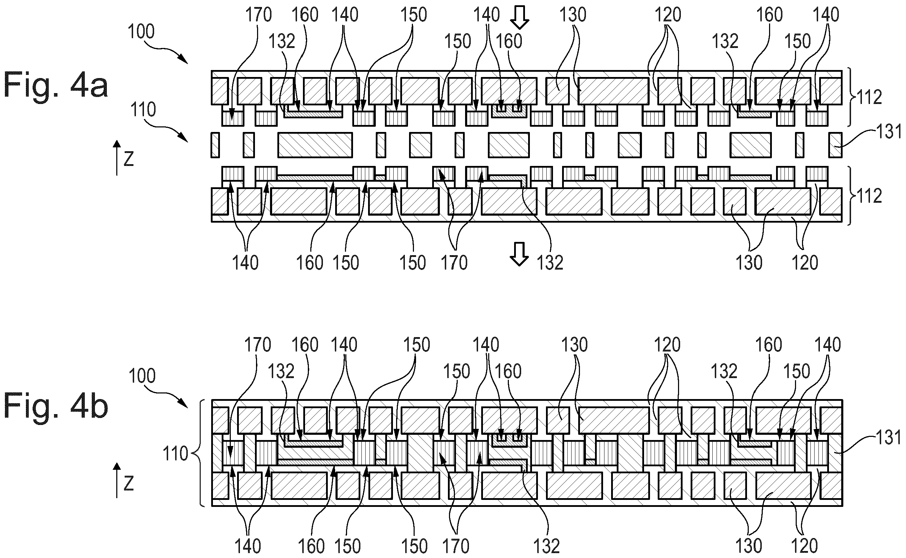

Figure 3a to Figure 3e in combination with Figure 4a and Figure 4b illustrate cross-sectional views of structures obtained during carrying out a preferred method of manufacturing a component carrier 100 according to an exemplary embodiment of the second aspect of the invention.

Figure 3a to Figure 3e in combination with Figure 5a and Figure 5b illustrate cross-sectional views of structures obtained during carrying out a further method of manufacturing a component carrier 100 according to an exemplary embodiment of the second aspect of the invention.

Referring to Figure 3a, a component carrier 100 comprising a stack 110 comprising two electrically conductive layer structures 120 and one electrically insulating layer structure 130 is shown. The electrically insulating layer structure 130 may be sandwiched between the respective two electrically conductive layer structures 120 regarding stacking direction Z. The electrically conductive layer structures 120 may be mechanically and/or electrically interconnected with each other by (vertical) through connections. In this example, the electrically conductive layer structure 120 located on the bottom side of the component carrier 100 may be structured into a plurality of separate portions, wherein each portion of the electrically conductive layer structure 120 has a surface 140 being exposed. Additionally, the electrically conductive layer structure 120 located on the top side of the component carrier 100 may be structured into another plurality of separate portions. Alternatively, the component carrier 100 may comprise an electrically conductive layer structure 120 exposed on one main surface, only.

Referring to Figure 3b, additionally to Figure 3a, a temporary electrically insulating layer 139 is provided on the bottom electrically conductive layer structure 120. The temporary electrically insulating layer 139 may cover the main surface of the (plurality of separate portions of the) electrically conductive layer structure 120. Additionally, the temporary electrically insulating layer 139 may cover the lateral surface of the (plurality of separate portions of the) electrically conductive layer structure 120 and/or the main surface of the electrically insulating layer structure 130. In an example, the temporary electrically insulating layer 139 may be a photo resist. Alternatively, the temporary electrically insulating layer 139 may be a dry film. Preferably, the temporary electrically insulating layer 139 may be processable, for example by a laser beam. In an example, the temporary electrically insulating layer 139 may be applied as an entire layer.

Referring to Figure 3c, in comparison to Figure 3b at least a portion of the temporary electrically insulating layer 139 is structured, in particular partially removed, in order the expose the below laying electrically conductive layer structure 120 and/or electrically insulating layer structure 130. Thereby, the main surface and/or the lateral surface of the electrically conductive layer structure 120 is exposed. For example, the structuring process may be done by exposing the temporary electrically insulating layer 139 to electromagnetic light and a subsequent development process. Alternatively, the structuring process may comprise a laser assisted process and/or a plasma process and/or a reactive ion etching process. Preferably, the portion of the temporary electrically insulating layer 139 which was subjected to the structuring process may create the at least one second portion 160 and the portion of the temporary electrically insulating layer 139 which was not subjected to the structuring process may create the at least one first portion 150. This process step may divide surface 140 of the electrically conductive layer structure 120 in at least one first portion 150 and at least one second portion 160, wherein the at least one first portion 150 and the at least one second portion 160 being adjacent one to the other. In an example, one electrically conductive layer structure 120 may comprise at least one first portion 150 and the at least one second portion 160. In another not shown alternative example, one electrically conductive layer structure 120 may comprise at least one first portion 150 and another electrically conductive layer structure 120 may comprise at least one second portion 160.

Referring to Figure 3d, portions of the electrically conductive layer structure 120 being exposed in Figure 3c are subjected to a surface treatment process step, in particular an oxidation step. Thereby the exposed surface 140 of the at least one second portion 160 may be chemically converted, for example copper is transformed into copper oxide, and thereby a chemical composition 132 may be provided on the at least one second portion 160. Alternatively, the surface treatment process step may comprise converting a metal into a metal oxide or a metal nitride. Preferably, the surface treatment process step may be performed on the exposed at least one second portion 160 only. This may have the effect of affecting and/or changing the physical properties, for example the electrical conductivity and/or the thermal conductivity and/or the surface energy, of the at least one second portion 160 and comparison with the at least one first portion 150. In an example, the thickness of the chemical composition 132 in stacking direction Z may be different, in particular thinner, than the electrically conductive layer structure 120 and/or the electrically insulating layer structure 130.

Referring to Figure 3e, in comparison to Figure 3d the temporary electrically insulating layer 139 is fully removed from the component carrier 100. Alternatively, at least a portion of the temporary electrically insulating layer 139 may remain on the surface of the stack 110. The consequent exposed portion of the electrically conductive layer structure 120, in particular that not subjected to the surface treatment process step, corresponds to the at least one first portion 150. In an example, (at least a portion of) the at least one electrically conductive layer structure 120 previously subjected to a surface treatment process step may be fully covered by the chemical composition 132 at its main surface and its lateral surface. Alternatively, (at least a portion of) the at least one electrically conductive layer structure 120 previously subjected to a surface treatment process step may be partially covered by the chemical composition 132. In other words, at least a portion of the main surface and/or the lateral surface of the (at least a portion of the) electrically conductive layer structure 120 may be free from the chemical composition 132. The temporary electrically insulating layer 139 may be removed by a stripping process.

Referring to Figure 4a, in comparison to Figure 3e, (copper) nanowires 170 are provided, in particular grown, on the resulting first portions 150. Preferably, on every first portion 150 (copper) nanowires 170 may be provided. Alternatively, at least a portion of the first portion 150 may be free from metallic nanostructures and/or microstructures 170. Close by lateral adjacent chemical composition 132 may interfere the growing of (copper) nanowires 170 and thus a portion of the at least one first portion 150 may be free from (copper) nanowires. Additionally or alternatively, the electrically insulating material and/or said coating layer 136 may interfere the growing of the (copper) nanowires 170 when being located in close by lateral adjacent position. Preferably, the (copper) nanowires 170 may be provided on the main surface of the at least one first portion 150 of the electrically conductive layer structure 120. Additonally or alternatively, the (copper) nanowires 170 may be provided on the lateral surface of the at least one first portion 150 of the electrically conductive layer structure 120. Preferably, the (copper) nanowires 170 may be provided on the at least one first portion 150 only. According to an embodiment, providing the (copper) nanowires 170 comprises a galvanic process and/or a wet chemical process without application of electric current. Alternatively, providing the (copper) nanowires 170 may include a physical vapour deposition process and/or a chemical vapour deposition process.

Figure 4a depicts an exploded view of the stack 110 of the component carrier 100, according to a further exemplary embodiment of the present invention. The component carrier 100 comprises two respective sub-stacks 112. Thereby the sub-stacks 112 are located such, that the respective electrically conductive layer structures 120 comprising the respective (copper) nanowires 170 provided on the respective at least one first portions 150 are facing each other. In between the sub-stacks 112 regarding stacking direction Z an underfilling material 131 is provided. Additionally or alternatively, an electrically insulating layer structure 130 may be provided between the respective sub-stacks 112. The underfilling material 131 may comprise at least one cut-out portion. Preferably, the cut-out portion may overlap in stacking direction Z with the (copper) nanowires 170 of the respective sub-stack 112. Preferably, the underfilling material 131 may be different compared to the electrically insulating layer structure 130 in term of material and/or material composition.

Referring to Figure 4b, after applying thermal energy and/or elevated pressure, for example larger than 80 °C and/or 1.5 bars, on the stack 110 according to Figure 4a, a component carrier 100 similar to Figure 1 is created. Thereby the underfilling material 131 may adhere to the electrically insulating layer structure 130 and/or the electrically conductive layer structure 120 and/or the chemical composition 132 and/or the (copper) nanowires 170 and/or sub-stacks 112. Since during the application of thermal energy and/or elevated pressure, the underfilling material 131 may be at least partially flow able and thus may get in direct contact with the lateral walls of the electrically insulating layer structure 130 and/or the electrically conductive layer structure 120 and/or the chemical composition 132 and/or the (copper) nanowires 170 and/or sub-stacks 112. This may create a component carrier 100 having a high integrity and/or good adhesion between the respective different layers. Additionally or alternatively, the (copper) nanowires 170 of the respective sub-stacks 112 may get in direct contact and/or intermingle one to each other. This may a reliable mechanical and/or electrical interconnection between the two adjacent sub-stacks 112.

Referring to Figure 5a, the figure depicts an exploded view of the stack 110 of the component carrier 100, according to a further exemplary embodiment of the present invention. The component carrier 100 also comprises two sub-stacks 112, as Figure 4a. However, in Figure 5a, the bottom sub-stack 112 is free from the chemical composition 132 and/or metallic (copper) nanowires 170. The bottom sub-stack 112 comprises an electrically insulating layer structure 130 sandwiched between two adjacent electrically conductive layer structure 120 regarding stacking direction Z. One of the electrically conductive layer structures 120 may be structured, in this case the top electrically conductive layer structure. The sub-stacks 112 may be located such, that the respective electrically conductive layer structures 120 comprising the respective (copper) nanowires 170 provided on the respective at least one first portions 150 of the first sub-stack 112 is facing the structured top electrically conductive layer structure 120 of the other sub-stack 112. In between the sub-stacks 112 regarding stacking direction Z an underfilling material 131 is provided. Additionally or alternatively, an electrically insulating layer structure 130 may be provided between the respective sub-stacks 112. The underfilling material 131 may comprise at least one cut-out portion. Preferably, the cut-out portion may overlap in stacking direction Z with the metallic nanostructures and/or microstructures 170 of the respective sub-stack 112.

Referring to Figure 5b, after applying thermal energy and/or elevated pressure, for example larger than 80 °C and/or 1.5 bars, on the stack 110 according to Figure 4a, a component carrier 100 similar to Figure 1 is created. In comparison to Figure 4b, the chemical composition 132 is located only in one level regarding stacking direction Z. The (copper) nanowires 170 of one sub-stack 112 abutting to the opposed electrically conductive layer structure 120 of the other sub-stack 112 may ensure a reliable electrically and/or mechanical connection, since the (copper) nanowires 170 of the one sub-stack 112 may protrude into the opposed electrically conductive layer structure 120 of the other sub-stack 112. Optionally the component carrier 100 may be further processed, for example by a structuring process and/or etching process and/or plating process and/or lamination process.

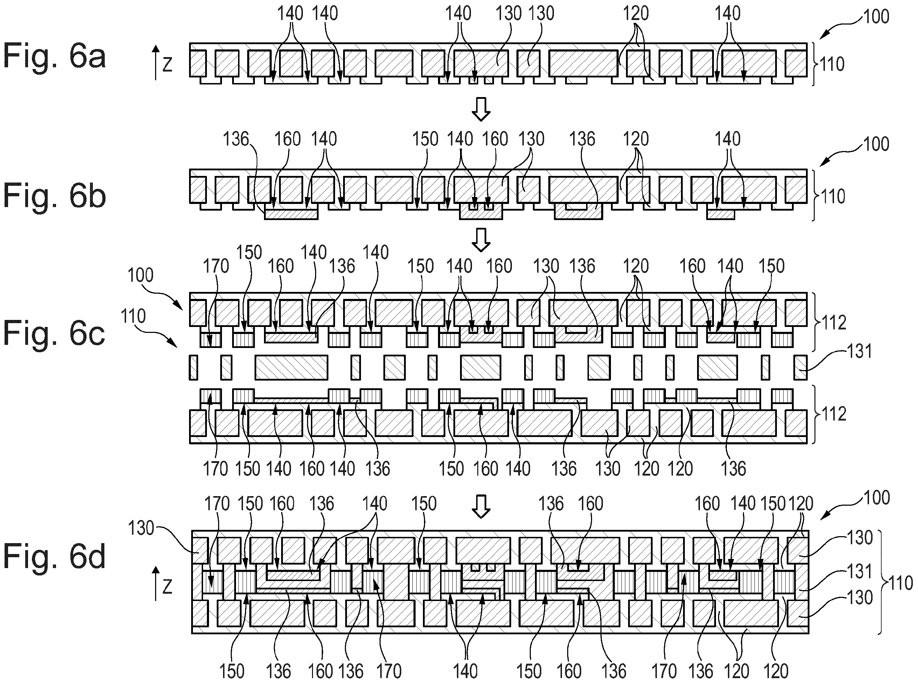

Figure 6a to Figure 6d illustrate cross-sectional views of structures obtained during carrying out another preferred method of manufacturing a component carrier 100 according to an exemplary embodiment of the second aspect of the invention.

Referring to Figure 6a, a component carrier 100 comprising a stack 110 comprising two electrically conductive layer structures 120 and one electrically insulating layer structure 130 is shown, similar to the component carrier 100 shown in Figure 3a.

Referring to Figure 6b, additionally to Figure 6a a coating layer 136 is provided at at least one surface 140 of the electrically conductive layer structure 120. Additionally or alternatively, an electrically insulating material may be provided at at least one surface 140 of the electrically conductive layer structure 120. Additionally, the coating layer 136 and/or the electrically insulating material may be provided at at least one surface 140 of the electrically insulating layer structure 130. The coating layer 136 and/or the electrically insulating material may be applied by a surface treatment process step and/or a coating step, in particular a screen printing process step. Alternatively, a three-dimensional printing step and/or a dispensing step may be used. In an example, the coating layer 136 and/or the electrically insulating material may be a photo resist, in particular a liquid photo resist. In another example, the a (liquid) photo resist may be applied on the surface 140 of the second portion 160 (only). Preferably, the coating layer 136 and/or the electrically insulating material which was provided to the at least one portion of the surface 140 of the electrically conductive layer structure 120 by for example a coating step may create the at least one second portion 160 and another portion of the surface 140 of the electrically conductive layer structure 120 which was is free from the coating layer 136 and/or the electrically insulating material may create the at least one first portion 150. Thereby, the surface 140 of the electrically conductive layer structure 120 may be divided in at least one first portion 150 and at least one second portion 160. Dividing at least one surface 140 of said at least one electrically conductive layer structure into at least one first portion 150 and at least one second portion 160 may comprise the step of performing the surface treatment process step and/or the coating step to said second portion 160 only. Preferably, the coating layer 136 and/or electrically insulating material may be in direct contact with the main surface of the electrically conductive layer structure 120. Additionally or alternatively, the coating layer 136 and/or electrically insulating material may be in direct contact with the lateral surface of the electrically conductive layer structure 120. In an example the coating layer 136 and/or electrically insulating material may be provided at a portion of an electrically conductive layer structure 120. Additionally or alternatively, the coating layer 136 and/or electrically insulating material may be provided such that the coating layer 136 and/or electrically insulating material may cover an entire surface 140 of one electrically conductive layer structure 120 and/or that the coating layer 136 and/or electrically insulating material is in contact with at least two, in particular two adjacent, electrically conductive layer structures 120.

Referring to Figure 6c, in addition to Figure 6b (copper) nanowires 170 are provided on the surface 140 of the at least one first portion 150. Thereby (copper) nanowires 170 may be grown on the exposed surface 140 of the first portion 150. In an example, the (copper) nanowires 170 may be in direct contact with the coating layer 136 and/or the electrically insulating material, in particular at the lateral surface of the coating layer 136 and/or the electrically insulating material. Alternatively, the (copper) nanowires 170 may be free from direct contact with the coating layer 136 and/or the electrically insulating material. Similar to Figure 4a, the stack 110 of Figure 6c comprises an underfilling material 131 located between two sub-stacks 112. Thereby the sub-stacks 112 are located such, that the respective electrically conductive layer structures 120 comprising the respective (copper) nanowires 170 provided on the respective at least one first portions 150 are facing each other. In between the sub-stacks 112 regarding stacking direction Z an underfilling material 131 is provided. Additionally or alternatively, an electrically insulating layer structure 130 may be provided between the respective sub-stacks 112. The underfilling material 131 may comprise at least one cut-out portion. Preferably, the cut-out portion may overlap in stacking direction Z with the (copper) nanowires metallic nanostructures and/or microstructures 170 of the respective sub-stack 112. Preferably, the underfilling material 131 may be different compared to the electrically insulating layer structure 130 in term of material and/or material composition.

Referring to Figure 6d, a component carrier 100 is created after applying elevated temperature, for example larger than 80 °C, and/or pressure, for example larger than 1.5 bars, to the stack 110 shown in Figure 6c. The component carrier 100 in Figure 6d differs from the component carrier 100 in Figure 4b in that the material of the coating layer 136 is exchanged by the chemical composition 132 and vice versa.

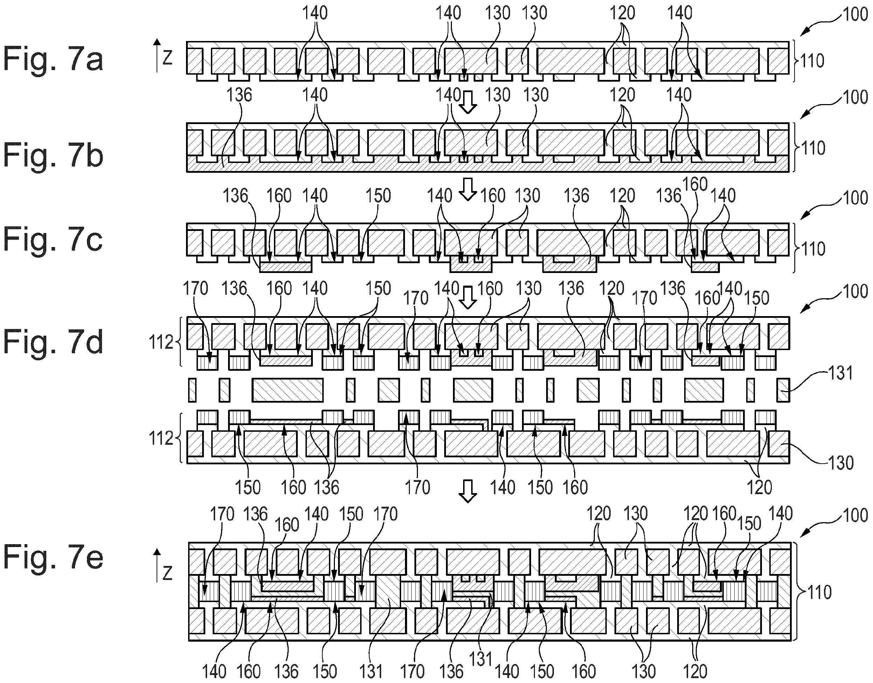

Figure 7a to Figure 7e illustrate cross-sectional views of structures obtained during carrying out a further preferred method of manufacturing a component carrier 100 according to an exemplary embodiment of the second aspect of the invention.

Referring to Figure 7a, a component carrier 100 comprising a stack 110 comprising two electrically conductive layer structures 120 and one electrically insulating layer structure 130 is shown, similar to the component carrier 100 shown in Figure 3a.

Referring to Figure 7b, additionally a coating layer 136 is applied on the bottom of the stack 110. Preferably, the coating layer 136 may be in direct contact with the surface 140, in particular the main surface and/or the lateral surface, of the electrically conducting layer structure 120 and/or the main surface of the electrically insulating layer structure 130. In an example, the coating layer 136 may cover the entire bottom (main) surface of the stack 110. Alternatively, a portion of the bottom surface of the stack 110 may be covered by the coating layer 136. In an example, the coating layer 136 may interact with electromagnetic light, in particular a laser beam. In another example, the coating layer 136 may be a photo imageable material, in particular a photo imageable dielectric material. Alternatively, the coating layer 136 may be structure able by another physical and/or chemical process, for example a plasma assisted process.

Referring to Figure 7c, the layer of coating layer 136 may be partially removed from at least one portion by a surface treatment process step. Thereby, the surface 140 of the electrically conductive layer structure 120may be exposed. Additionally, the main surface of the electrically insulating layer structure 130 may be exposed. Preferably, the coating step in combination with the following process treatment step may divide at least one surface 140 of said at least one electrically conductive layer structure 120 into at least one first portion 150 and at least one second portion 160, since the portion of the surface 140 of the electrically conductive layer structure 120 still covered by the coating layer 136 after the surface treatment process may be assigned or associated to the at least one second portion 160 and/or the portion of the surface 140 of the electrically conductive layer structure 120 being free from the coating layer 136 after the surface treatment process may be assigned or associated to the at least one first portion 150.

Referring to Figure 7d, in addition to Figure 7c (copper) nanowires 170 are provided on the surface 140 of the at least one first portion 150. Thereby (copper) nanowires 170 may be grown on the exposed surface 140 of the first portion 150. In an example, the (copper) nanowires 170 may be in direct contact with the coating layer 136, in particular at the lateral surface of the coating layer 136. Alternatively, the (copper) nanowires 170 may be free from direct contact with the coating layer 136. Similar to Figure 4a, the stack 110 of Figure 7d comprises an underfilling material 131 located between two sub-stacks 112. Thereby the sub-stacks 112 are located such that, the respective electrically conductive layer structures 120 comprising the respective (copper) nanowires 170 provided on the respective at least one first portions 150 are facing each other. In between the sub-stacks 112 regarding stacking direction Z an underfilling material 131 is provided. Additionally or alternatively, an electrically insulating layer structure 130 may be provided between the respective sub-stacks 112. The underfilling material 131 may comprise at least one cut-out portion. Preferably, the cut-out portion may overlap in stacking direction Z with the (copper) nanowires 170 of the respective sub-stack 112. Preferably, the underfilling material 131 may be different compared to the electrically insulating layer structure 130 in term of material and/or material composition.

Referring to Figure 7e, a component carrier 100 is created after applying elevated temperature, for example larger than 80 °C, and/or pressure, for example larger than 1.5 bars, to the stack 110 shown in Figure 7d. The component carrier 100 in Figure 6d differs from the component carrier 100 in Figure 4b in that the material of the coating layer 136 is exchanged by the chemical composition 132 and vice versa.

The component carrier 100 as shown in Figure 1 or similar to the one shown in Figure 1 can be manufactured by a combination of the explained process steps described in Figure 3a to Figure 3e in combination with Figure 4a and Figure 4b and/or Figure 3a to Figure 3e in combination with Figure 5a and Figure 5b and/or Figure 6a to Figure 6d and/or Figure 7a to Figure 7e.

Preferably, Figure 2, Figure 4b, Figure 5b, Figure 6d and/or Figure 7e may be further treated by at least one process step, for example an etching process step and/or a galvanic plating step, in order to structure the exposed electrically conductive layer structure 120 (of the exposed main surfaces). Optionally, the exposed electrically conductive layer structure 120 of the stack 110 may comprise a surface finish, for example comprising gold and/or nickel and/or palladium, and/or the exposed electrically insulating layer structure 130 of the stack 110 may comprise a solder resist (see Figure 1).

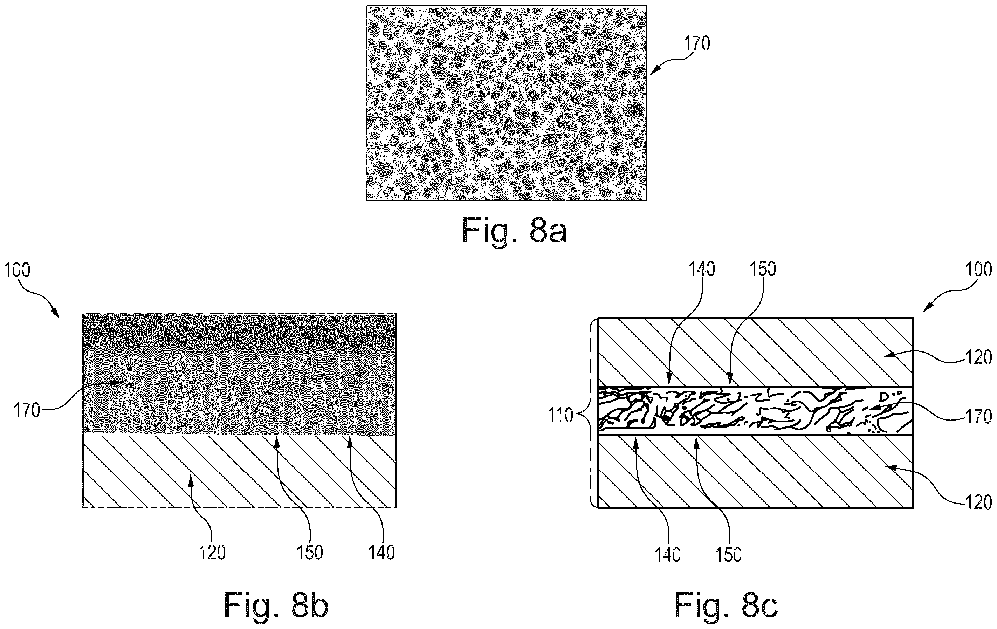

Referring to Figure 8a, an enlarged view of a micro- and/or nano-porous surface representing the metallic nanostructures and/or micro structures 170 is illustrated according to an exemplary embodiment of the present invention. The micro- and/or nano-porous body may comprise open and/or closed pores. In an example, the extension of the pores may be in range from 10 nm to 10 µm, in particular in the range from 50 nm to 1 µm. Preferably, the metallic nanostructure and/or microstructures 170 may be nano-porous copper. Alternatively, the metallic nanostructure and/or microstructures 170 may be a nano-porous material being free from copper, for example titanium and/or chromium and/or nickel and/or gold. In another example, the metallic nanostructure and/or microstructures 170 may have an electrical conductivity higher than 10^6 S/m. Preferably, the micro- and/or nano-porous body may be suitable to be deformed, in particular when it gets in contact with another micro- and/or nano-porous body and/or an electrically conductive layer structure 120 and/or an electrically insulating layer structure 130. In an example, the micro- and/or nano-porous body may be deformed during a lamination process, when pressure is applied. Nevertheless, the micro- and/or nano-porous body may not break and thus ensure a reliable electrically connection.

Referring to Figure 8b, a cross-sectional view of a component carrier 100 is illustrated according to an exemplary embodiment of the present invention where the metallic nanostructures and/or microstructures 170 comprise metallic nanowires, in particular copper nanowires. The component carrier 100 may be a magnified view of a component carrier 100 similar to Figure 1, wherein an electrically conductive layer structure 120 comprising a surface 140 having a first portion 150 is shown in detail. On the surface 140 of the first portion 150 a plurality of (copper) nanowires 170 are provided. Preferably, the (copper) nanowires 170 may be grown on the first portion 150 according the second aspect of the current invention. Thereby the (copper) nanowires 170 may be in direct contact with the electrically conductive layer structures 120 and/or with each other.

Referring to Figure 8c, a cross-sectional view of a component carrier 100 is illustrated according to an exemplary embodiment of the present invention. The component carrier 100 may be another magnified view of a component carrier similar to Figure 1, wherein the component carrier 100 comprising a stack 110 comprising two adjacent electrically conductive layer structures 120 is shown in detail. Each respective electrically conductive layer structure 120 comprises a surface 140 comprising a first portion 150, wherein on each respective first portion 150 (copper) nanowires 170 are provided. The respective (copper) nanowires 170 are located such that they are facing each other. Moreover, the respective (copper) nanowires 170 are intermingled with each other. This may be a result of creating the component carrier 100 according to the second aspect of the present invention, in particular providing elevated temperatures and/or elevated pressure during a manufacturing step. The intermingled (copper) nanowires 170 may ensure a reliable mechanical and/or electrical connection between the adjacent two respective electrically conductive layer structures 120.

It should be noted that the term "comprising" does not exclude other elements or steps and the "a" or "an" does not exclude a plurality. Also, elements described in association with different embodiments may be combined.

Implementation of the invention is not limited to the preferred embodiments shown in the figures and described above. Instead, a multiplicity of variants is possible which use the solutions shown and the principle according to the invention, whose scope is defined by the appended claims.

### List of Reference Signs

- 100: component carrier
- 110: stack
- 111: zoom of stack
- 112: sub-stack
- 120: electrically conductive layer structure
- 130: electrically insulating layer structure
- 131: protecting material, underfilling material
- 132: chemical composition
- 136: coating layer
- 139: temporary electrically insulating layer
- 140: surface of electrically conductive layer structure
- 150: first portion
- 152: further first portion
- 160: second portion
- 162: further second portion
- 170: metallic nanostructures and/or microstructures, nanowires
- 180: first sub-carrier
- 182: second sub-carrier
- 190: distancing element
- 192: component

- Z: thickness direction

## Claims

1. A component carrier (100), wherein the component carrier (100) comprises:
a stack (110) comprising at least one electrically conductive layer structure (120) and at least one electrically insulating layer structure (130),
wherein at least one surface (140) of said at least one electrically conductive layer structure (120) is divided in at least one first portion (150) and at least one second portion (160), said at least one first portion (150) and said at least one second portion (160) being adjacent one to the other, said at least one first portion (150) having a higher conductivity with respect to that of said at least one second portion (160),
wherein on said at least one first portion (150) metallic nanostructures and/or microstructures (170) are provided.

2. The component carrier (100) according to claim 1, wherein an electrically insulating material is provided, said electrically insulating material covering said at least one second portion, and/or
wherein a chemical composition (132), in particular a metal salt, more in particular a metal oxide or a metal nitride, is provided, said chemical composition (132) covering said at least one second portion (160), and/or
wherein a coating layer (136) is provided, said coating layer (136) covering said at least one second portion (160).

3. The component carrier (100) according to claims 2, wherein said electrically insulating material and/or said chemical composition (132) and/or said coating layer (136) is located, in particular sandwiched, between said at least one second portion (160) and the at least one electrically insulating layer structure (130).

4. The component carrier (100) according to any of the claims 1 to 3, wherein the reflection of electromagnetic waves of said at least one first portion (150) is different compared to the reflection of electromagnetic waves of said at least one second portion (160).

5. The component carrier (100) according to any of the claims 1 to 4, wherein the metallic nanostructures and/or microstructures (170) comprise nanowires, in particular metallic nanowires, and/or a micro- and/or nano-porous body, in particular nano-porous copper.

6. The component carrier (100) according to any of the claims 1 to 5, wherein the metallic nanostructures and/or microstructures (170) are encircled by the electrically insulating layer structure (130) and/or by said electrically insulating material and/or by said chemical composition (132) and/or by said coating layer (136).

7. The component carrier (100) according to any of the claims 1 to 6, wherein the component carrier (100) comprises at least two electrically conductive layer structures (120), in particular opposed one to each other, each of the at least two electrically conductive layer structures (120) comprise the respective first and second portions (150, 160).

8. The component carrier (100) according to any of the claims 1 to 8, wherein the component carrier (100) comprises at least two sub-carriers (180, 182), in particular at least a first sub-carrier (180) and a second sub-carrier (182), each comprising at least one electrically conductive layer structure (120) , wherein the at least two sub-carriers (180, 182) are stacked one above the other in thickness direction (Z), in particular with the respective at least one electrically conductive layer structure (120) of the first sub-carrier (180) opposed to the at least one electrically conductive layer structure (120) of the second sub-carrier (182).

9. The component carrier (100) according to any of the claims 7 to 8, wherein the metallic nanostructures and/or microstructures (170) are located on only one of said two opposed electrically conductive layer structures (120), in particular the metallic nanostructures and/or microstructures (170) are configured to abut against the opposed electrically conductive layer structure (120), more in particular the metallic nanostructures and/or microstructures (170) are provided on one of said two opposed electrically conductive layer structures (120) and are configured to abut against the surface (140) of the at least one first portion (150) of the opposed electrically conductive layer structure (150).

10. The component carrier (100) according to any of the claims 7 to 8, wherein the metallic nanostructures and/or microstructures (170) are provided on the at least one first portion (150) of each the two opposed electrically conductive layer structures.

11. The component carrier (100) according to any of the claims 7 to 10, wherein the vertical distance between the two opposed first portions (150) is different than the vertical distance between the two opposed second portions (160).

12. The component carrier (100) according to any of the claims 7 to 11, wherein the amount of the first and/or second portions (150, 160) of one of the two opposed electrically conductive layer structures (120) is different than the respective amount the first and/or second portions (150, 160) of the opposed electrically conductive layer structures (120).

13. The component carrier (100) according to any of the claims 7 to 12, wherein at least one distancing element (190) is located between the at least two opposed electrically conductive layer structures (120) and/or the at least two opposed electrically insulating layer structures (130).

14. The component carrier (100) according to any of the claims 7 to 13, wherein a protecting material (131) is located between the two opposed first portions (120).

15. A method of manufacturing a component carrier (100), wherein the method comprises:
providing a stack (110) comprising at least one electrically conductive layer structure (120) and at least one electrically insulating layer structure (130),
dividing at least one surface (140) of said at least one electrically conductive layer structure (120) into at least one first portion (150) and at least one second portion (160),
said at least one first portion (150) and said at least one second portion (160) being adjacent one to the other, said at least one first portion (150) has a higher conductivity with respect to that of the at least one second portion (160); and
providing metallic nanostructures and/or microstructures (170) on said first portion.
